(19) Europäisches Patentamt

European Patent Office

Office européen des brevets

(11) **EP 1 078 461 B1**

(12) **EUROPÄISCHE PATENTSCHRIFT**

(45) Veröffentlichungstag und Bekanntmachung des Hinweises auf die Patenterteilung:
**18.09.2002 Patentblatt 2002/38**

(51) Int Cl.⁷: **H03K 19/08**

(86) Internationale Anmeldenummer:
**PCT/DE99/00715**

(21) Anmeldenummer: **99919077.0**

(22) Anmeldetag: **15.03.1999**

(87) Internationale Veröffentlichungsnummer:
**WO 99/057813 (11.11.1999 Gazette 1999/45)**

(54) **SCHALTUNGSANORDNUNG MIT EINZELELEKTRON-BAUELEMENTEN UND VERFAHREN ZU DEREN BETRIEB**

CIRCUIT WITH INDIVIDUAL ELECTRON COMPONENTS AND METHOD FOR THE OPERATION THEREOF

CIRCUIT A COMPOSANTS A ELECTRONS INDIVIDUELS ET PROCEDE PERMETTANT SON FONCTIONNEMENT

(84) Benannte Vertragsstaaten:
**DE FR GB IT**

(30) Priorität: **05.05.1998 DE 19820050**

(43) Veröffentlichungstag der Anmeldung:
**28.02.2001 Patentblatt 2001/09**

(73) Patentinhaber: **Infineon Technologies AG**
**81669 München (DE)**

(72) Erfinder:
• **RÖSNER, Wolfgang**
**D-81739 München (DE)**
• **RAMCKE, Ties**
**D-81739 München (DE)**
• **RISCH, Lothar**
**D-85579 Neubiberg (DE)**

(74) Vertreter: **Jannig, Peter, Dipl.-Ing.**
**Jannig & Repkow,**
**Patentanwälte,**
**Klausenberg 20**
**86199 Augsburg (DE)**

(56) Entgegenhaltungen:
**EP-A- 0 562 751**

• **CHEN R H ET AL: "SINGLE-ELECTRON TRANSISTOR LOGIC" APPLIED PHYSICS LETTERS, Bd. 68, Nr. 14, 1. April 1996 (1996-04-01), Seiten 1954-1956, XP000585115 ISSN: 0003-6951**
• **MASU K ET AL: "STABLE OPERATION OF SINGLE ELECTRON LOGIC CIRCUITS WITH FEED-BACK LOOP" INTERNATIONAL CONFERENCE ON SOLID STATE DEVICES AND MATERIALS, 21. August 1995 (1995-08-21), Seite 1079/1080 XP000544896**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung bezieht sich auf eine Schaltungsanordnung mit Einzelelektron-Bauelementen, die unter anderem als Logikschaltung geeignet ist.

Integrierte Schaltungsanordnungen für Logikanwendungen werden derzeit hauptsächlich in CMOS-Technologie realisiert. Bei fortschreitender Bauelemente-Verkleinerung wird diese herkömmliche CMOS-Technologie an ihre Grenzen stoßen.

Im Hinblick auf eine weitere Miniaturisierung sind sogenannte Einzelelektron-Bauelemente vorgeschlagen worden, in denen Schaltvorgänge mit einzelnen Elektronen realisiert werden. Eine Untersuchung über derartige Einzelelektron-Bauelemente ist zum Beispiel aus W. Rösner et al, Microelectronic Engineering, Bd. 27, 1995, Seiten 55 bis 58, bekannt. Einzelelektron-Bauelemente umfassen Tunnelelemente, die über Tunnelkontakte mit benachbarten Anschlüssen verbunden sind. Ladungsübertritte über diese Tunnelkontakte erfolgen sowohl über den quantenmechanischen Tunneleffekt als auch durch einfache thermische Überwindung einer Potentialbarriere, wobei diese Ladungsübertritte hinreichend selten auftreten. Die Tunnelelemente sind zum Beispiel als kleine leitfähige Inseln realisiert, die von einer isolierenden Struktur umgeben sind. Wird an die beiden Anschlüsse eine Spannung U angelegt, für die die Bedingungen für Coulomb-Blockade erfüllt ist, das heißt für deren Betrag $|U| < e/(2C)$ gilt, so kann sich die Ladung des Tunnelelementes aufgrund der Potentialverhältnisse nicht verändern, sofern für die thermische Energie $\frac{kT}{e} << \frac{e}{2C}$ gilt.

Dabei ist k die Stefan Boltzmann-Konstante, T die Temperatur, e die Elektronenladung, C die Kapazität des Tunnelelementes.

Bei Anlegen einer höheren Spannung können Elektronen über einen der Tunnelkontakte auf das Tunnelelement fließen. Diese Einzelelektron-Bauelemente werden so betrieben, daß jeweils ein Übertritt einzelner Elektronen erfolgt.

Durch Ansteuerung des Tunnelelementes über eine Gateelektrode, die das Tunnelelement kapazitiv beeinflußt, ohne daß es im Betriebsspannungsbereich zu Tunnelübergängen käme, ist es möglich, die Coulomb-Blockade aufzuheben. Sofern an der Gateelektrode eine geeignete elektrische Ladung wirksam ist, weist das Einzelelektron-Bauelement eine in etwa lineare, durch den Nullpunkt gehende Stromspannungskennlinie auf. Ein derartiges gategesteuertes Einzelelektron-Bauelement wird in der Literatur als Einzelelektron-Transistor bezeichnet.

Der Erfindung liegt das Problem zugrunde, eine Schaltungsanordnung mit Einzelelektron-Bauelementen anzugeben, die unter anderem als Logikschaltung geeignet ist. Darüber hinaus soll ein Betriebsverfahren für eine derartige Schaltungsanordnung angegeben werden.

Dieses Problem wird erfindungsgemäß gelöst durch eine Schaltungsanordnung nach Anspruch 1 sowie ein Verfahren zu deren Betrieb nach Anspruch 7. Weitere Ausgestaltungen der Erfindung gehen aus den Unteransprüchen hervor.

Die Schaltungsanordnung weist mindestens einen Schaltungsblock mit einem ersten Einzelelektron-Transistor, einem zweiten Einzelelektron-Transistor, einem dritten Einzelelektron-Transistor, einem vierten Einzelelektron-Transistor und einem fünften Einzelelektron-Transistor auf. Dabei sind der erste Einzelelektron-Transistor, der zweite Einzelelektron-Transistor und der dritte Einzelelektron-Transistor in Reihe zwischen einen ersten Hauptknoten und einen Ausgang geschaltet. Zwischen dem ersten Einzelelektron-Transistor und dem zweiten Einzelelektron-Transistor ist dabei ein zweiter Hauptknoten und zwischen dem zweiten Einzelelektron-Transistor und dem dritten Einzelelektron-Transistor ein dritter Hauptknoten vorgesehen.

Der vierte Einzelelektron-Transistor ist zwischen den zweiten Hauptknoten und einen ersten Versorgungsspannungsanschluß und der fünfte Einzelelektron-Transistor zwischen den dritten Hauptknoten und den ersten Versorgungsspannungsanschluß geschaltet. Der zweite Hauptknoten ist dabei kapazitiv mit einem zweiten Versorgungsspannungsanschluß und der dritte Hauptknoten kapazitiv mit einem dritten Versorgungsspannungsanschluß verbunden.

Die Gateelektrode des ersten Einzelelektron-Transistors ist mit einem ersten Steuerspannungsanschluß, die Gateelektrode des zweiten Einzelelektron-Transistors mit einem zweiten Steuerspannungsanschluß und die Gateelektrode des dritten Einzelelektron-Transistors mit einem dritten Steuerspannungsanschluß verbunden. Die Gateelektrode des vierten Einzelelektron-Transistors ist mit dem ersten Hauptknoten und die Gateelektrode des fünften Einzelelektron-Transistors ist mit dem zweiten Hauptknoten verbunden. Der erste Hauptknoten ist kapazitiv zwischen einen vierten Versorgungsspannungsanschluß und einen fünften Versorgungsspannungsanschluß geschaltet, wobei sich der erste Versorgungsspannungsanschluß von dem fünften Versorgungsspannungsanschluß unterscheidet.

Die Einzelelektron-Transistoren weisen jeweils ein Tunnelelement auf, das über zwei Tunnelkontakte mit Anschlüssen verbunden ist und das über eine Gateelektrode kapazitiv beeinflußbar ist. Da die Höhe der Potentialbarriere zwischen den beiden Anschlüssen abhängig von der an der Gateelektrode vorhandenen Ladungsmenge ist und da an der Gateelektrode des vierten Einzelelektron-Transistors eine auf dem ersten Hauptknoten befindliche Ladung und an der Gateelektrode des fünften Einzelelektron-Transistors eine auf dem zweiten Hauptknoten befindliche Ladung wirksam sind, lassen sich mit Hilfe dieser Schaltungsanordnung logische Verknüpfungen zwischen Signalladungen, die sich auf dem ersten Hauptknoten, dem zweiten Hauptknoten und dem dritten Hauptknoten befinden und die logische Daten darstellen, realisieren. Dazu werden Ladungsträger, die dem entsprechenden logischen Wert zugeordnet werden, auf den ersten Hauptknoten, den zweiten Hauptknoten und/oder den dritten Hauptknoten aufgebracht. Zum Beispiel wird dem logischen Wert Eins ein Elektron und dem logischen Wert Null kein Elektron zugeordnet.

Über die Tunnelkontakte der Einzelelektron-Transistoren können Ladungsübertritte sowohl durch quantenmechanischen Tunneleffekt als auch durch hinreichend seltene thermische Überwindung einer Potentialbarriere erfolgen. Ist der Tunnelwiderstand der Tunnelkontakte $R_T > R_K = h/e^2 \approx 26$ kΩ wobei $R_K$ der Klitzing-Widerstand, h das Planck'sche Wirkungsquantum und e eine Elektronenladung ist, so sind die Ladungsträger auf einer der Seiten der Potentialbarriere lokalisiert und die Mehrzahl der Ladungsübertritte über die Potentialbarriere erfolgt durch Elementarprozesse. Vorzugsweise ist der Tunnelwiderstand der Tunnelkontakte jeweils > 100 kΩ.

Als Tunnelelemente kommen alle Strukturen in Betracht, die einen elektrisch leitfähigen Bereich umfassen und die über eine Isolationsstruktur gegenüber benachbarten elektrisch leitfähigen Bereichen isoliert sind. Über die Isolationsstruktur sind die elektrisch leitfähigen Bereiche durch Tunnelkontakte verbunden. Als Tunnelelement sind insbesondere Strukturen geeignet, die einen leitfähigen Kern und eine den leitfähigen Kern umgebende isolierende Hülle umfassen. Der Durchmesser des Tunnelelementes liegt dabei vorzugsweise zwischen 1 und 10 nm. Die Kapazität der Tunnelelemente ist in diesem Größenbereich so klein, daß die Schaltungsanordnung im Raumtemperaturbereich funktioniert. Insbesondere sind als Tunnelelemente Metallcluster mit organischen Liganden als isolierender Hülle, wie sie aus DE 42 12 220 A1 bekannt sind, oder Fullerene mit eingeschlossenem Metallkern geeignet.

Desweiteren sind als Tunnelelemente lithographisch strukturierte Metallschichten geeignet, wobei die Tunnelkontakte durch Oxidation einer solchen Metallschicht und nachfolgende Abscheidung und Strukturierung einer weiteren Metallschicht entstehen. Ferner sind als Tunnelelemente Delta-dotierte III-V Halbleiter geeignet. Im Rahmen einer molekularen Elektronik sind als Tunnelelemente auch Abschnitte einzelner Moleküle geeignet, die abhängig von ihrer Vorgeschichte unterschiedliche Ladungen tragen können. Der Ladungsübertritt zwischen solchen umladbaren Molekülabschnitten erfolgt entlang chemischer Bindungen.

Mit der Schaltungsanordnung lassen sich insbesondere eine OR-Verknüpfung, eine AND-Verknüpfung und eine XOR-Verknüpfung realisieren. Darüber hinaus ist die Schaltungsanordnung geeignet zur Addition von Werten, die auf dem ersten Hauptknoten, dem zweiten Hauptknoten und/oder dem dritten Hauptknoten gespeichert werden. Da die Schaltungsanordnung zur Addition von drei einstelligen Binärzahlen geeignet ist, stellt sie einen Volladdierer dar. Durch Vorsehen mehrerer Schaltungsblöcke, die im wesentlichen gleich aufgebaut sind wie der erstgenannte Schaltungsblock, und in denen jeweils der Ausgang des einen mit dem ersten Hauptknoten des benachbarten Schaltungsblocks verbunden ist, läßt sich ein Addierer für Binärzahlen beliebiger Länge aufbauen.

Die Verbindung zwischen dem zweiten Hauptknoten und dem zweiten Versorgungsspannungsanschluß bzw. dem dritten Hauptknoten und dem dritten Versorgungsspannungsanschluß erfolgt zum Beispiel über einen Kondensator. Alternativ kann diese Verbindung durch ein anderes kapazitives Element, zum Beispiel ein Einzelelektron-Bauelement oder einen Einzelelektron-Transistor realisiert werden.

Vorzugsweise ist in dem Schaltungsblock ein sechster Einzelelektron-Transistor vorgesehen, der zwischen den ersten Hauptknoten und den fünften Versorgungsspannungsanschluß geschaltet ist. In dieser Anordnung läßt sich über den sechsten Einzelelektron-Transistor der erste Hauptknoten beladen. Die auf den ersten Hauptknoten fließende Ladung ist dabei abhängig von der an der Gateelektrode des sechsten Einzelelektron-Transistors wirksamen Ladung und der an dem fünften Versorgungsspannungsanschluß wirksamen Ladung. Über den sechsten Einzelelektron-Transistor ist somit eine logische Verknüpfung zwischen der an der Gateelektrode des sechsten Einzelelektron-Transistors wirksamen Ladung und der am fünften Versorgungsspannungsanschluß wirksamen Ladung möglich. Mit anderen Worten: in dieser Ausgestaltung wird der erste Hauptknoten mit dem Ergebnis der Verknüpfung zwischen zwei Werten, deren zugehörige Ladungen an der Gateelektrode des sechsten Einzelelektron-Transistors bzw. am fünften Versorgungsspannungsanschluß wirksam sind, beaufschlagt.

Vorzugsweise wird die Gateelektrode des sechsten Einzelelektron-Transistors kapazitiv mit dem ersten Versorgungsspannungsanschluß verbunden. In diesem Fall kann an der Gateelektrode des sechsten Einzelelektron-Transistors eine Ladung, und somit ein logischer Wert, fest gespeichert werden.

Die Verbindung zwischen der Gateelektrode des sechsten Einzelelektron-Transistors und dem ersten Versorgungsspannungsanschluß bzw. zwischen dem ersten Hauptknoten und dem vierten Versorgungsspannungsanschluß erfolgt zum Beispiel über jeweils einen Kondensator oder ein anderes kapazitives Element.

Gemäß einer Ausgestaltung der Erfindung sind mehrere Schaltungsblöcke vorgesehen, die wie der erstgenannte Schaltungsblock aufgebaut sind und die in Reihe verschaltet sind, so daß der Ausgang eines der Schaltungsblöcke mit dem ersten Hauptknoten des benachbarten Schaltungsblocks verbunden ist. Diese Ausgestaltung der Schaltungsanordnung ist als Volladdierer geeignet, wobei die entsprechenden Stellen zweier zu addierender Binärzahlen jeweils auf den ersten Hauptknoten bzw. den zweiten Hauptknoten eines der Schaltungsblöcke aufgebracht werden. Zur Addition zweier Binärzahlen mit maximal n-Stellen sind dabei n-Schaltungsblöcke erforderlich. Zur Addition von Binärzahlen ist es ausreichend, wenn die Schaltungsblöcke jeweils fünf Einzelelektron-Transistoren aufweisen.

Weisen die Schaltungsblöcke sechs Einzelelektron-Transistoren auf, so ist diese Ausgestaltung der Erfindung für einen Multiplizierer von Binärzahlen geeignet. Zur Multiplikation zweier Binärzahlen mit maximal n Stellen sind n Schaltungsblöcke erforderlich. Zur Multiplikation einer ersten Binärzahl mit einer zweiten Binärzahl werden die Stellen der ersten Binärzahl jeweils am Gate des sechsten Einzelelektron-Transistors gespeichert. Die Stellen der zweiten Binärzahl werden seriell auf den fünften Versorgungsspannungsanschluß gelegt. Der erste Hauptknoten wird dann durch die Verknüpfung mit Hilfe des sechsten Einzelelektron-Transistors mit einer Signalladung beaufschlagt, die dem Produkt der beiden jeweiligen Stellen der ersten Binärzahl und der zweiten Binärzahl entspricht.

Zum Betrieb der Schaltungsanordnung wird vorzugsweise auf den ersten Hauptknoten, den zweiten Hauptknoten und den dritten Hauptknoten jeweils eine Ladungsträgermenge aufgebracht, die dem logischen Wert von zu verknüpfenden Größen entspricht. Dabei wird für den logischen Wert Eins zum Beispiel ein Elektron aufgebracht und für den logischen Wert Null kein Elektron aufgebracht. Abhängig vom logischen Wert der auf dem jeweiligen Hauptknoten gespeicherten Größe befinden sich somit Überschußladungsträger auf dem Knoten oder es befinden sich keine Überschußladungsträger auf dem Hauptknoten.

Eine logische Verknüpfung der Größen wird durch eine Kombination von Grundvorgängen gebildet. Dabei wird in einem ersten Grundvorgang die Gateelektrode des ersten Einzelelektron-Transistors so angesteuert, daß auf dem ersten Hauptknoten befindliche Überschußladungsträger auf den zweiten Hauptknoten fließen, sofern sich auf dem zweiten Hauptknoten zuvor keine Überschußladungsträger befinden und daß auf dem ersten Hauptknoten befindliche Überschußladungsträger auf das Tunnelelement des ersten Einzelelektron-Transistors fließt, sofern sich auf dem zweiten Hauptknoten Überschußladungsträger befinden. Nachfolgend wird die Gateelektrode des ersten Einzelelektron-Transistors so angesteuert, daß auf dem Tunnelelement des ersten Einzelelektron-Transistors befindliche Überschußladungsträger auf den ersten Hauptknoten fließen. Anschließend wird der zweite Versorgungsspannungsanschluß so angesteuert, daß auf dem zweiten Hauptknoten befindliche Überschußladungsträger nur dann über den vierten Einzelelektron-Transistor abfließen, wenn sich auf dem ersten Hauptknoten Signalladung befindet. Bei diesem Teilschritt wird ausgenutzt, daß die Gateelektrode des vierten Einzelelektron-Transistors mit dem ersten Hauptknoten verbunden ist. Bei den ersten beiden Teilschritten des ersten Grundvorgangs wird ausgenutzt, daß die Höhe der Potentialbarrieren in dem ersten Einzelelektron-Transistor von der am zweiten Hauptknoten wirksamen Ladung abhängig sind.

Durch den ersten Grundvorgang wird die Summe der am ersten Hauptknoten und zweiten Hauptknoten gespeicherten Größen gebildet.

In einem zweiten Grundvorgang wird die Summe von im zweiten Hauptknoten und im dritten Hauptknoten gespeicherten Größen gebildet. Dazu wird analog wie im ersten Grundvorgang die Gateelektrode des zweiten Einzelelektron-Transistors so angesteuert, daß auf dem zweiten Hauptknoten befindliche Überschußladungsträger auf den dritten Hauptknoten fließen, sofern sich auf dem dritten Hauptknoten zuvor keine Überschußladungsträger befinden und daß auf dem zweiten Hauptknoten befindliche Überschußladungsträger auf das Tunnelelement des zweiten Einzelelektron-Transistors fließen, sofern sich auf dem dritten Hauptknoten Überschußladungsträger befinden.

Nachfolgend wird die Gateelektrode des zweiten Einzelelektron-Transistors so angesteuert, daß auf dem Tunnelübergang des zweiten Einzelelektron-Transistors befindliche Überschußladungsträger auf den zweiten Hauptknoten fließen. Dann wird der dritte Versorgungsspannungsanschluß so angesteuert, daß auf dem dritten Hauptknoten befindliche Signalladung nur dann über den fünften Einzelelektron-Transistor abfließt, wenn sich auf dem zweiten Hauptknoten Überschußladungsträger befinden.

Bei dem zweiten Grundvorgang wird die Summe der auf dem zweiten Hauptknoten und dem dritten Hauptknoten gespeicherten Größen gebildet.

In einem dritten Grundvorgang wird Signalladung von einem Hauptknoten durch Ansteuerung des zwischen den benachbarten Hauptknoten befindlichen Einzelelektron-Transistors verschoben. Dieses Verschieben der Überschußladungsträger erfolgt sowohl vom ersten Hauptknoten auf den zweiten, vom zweiten Hauptknoten auf den dritten als auch vom dritten Hauptknoten auf den ersten Hauptknoten des benachbarten Schaltungsblocks oder vom dritten Hauptknoten zum Ausgang des letzten Schaltungsblocks.

Zur Multiplikation einer ersten binären Zahl mit einer zweiten binären Zahl werden die Stellen der ersten binären Zahl an die Gateelektroden des ersten Einzelelektron-Transistors der benachbarten Schaltungsblöcke angelegt. Nachfolgend wird sukzessive für alle Stellen der zweiten binären Zahl die Stelle der zweiten binären Zahl an den ersten Versorgungsspannungsanschluß angelegt, so daß der erste Hauptknoten mit einer von dem Produkt aus den entsprechenden Stellen der binären Zahlen abhängigen Ladungsmenge versehen wird. Nachfolgend wird für die Stelle der erste Grundvorgang, der zweite Grundvorgang und nochmals der erste Grundvorgang durchgeführt. Anschließend werden durch mehrfache Anwendung des dritten Grundvorgangs auf den dritten Einzelelektron-Transistor, den zweiten Einzelelektron-Transistor und den ersten Einzelelektron-Transistor auf dem dritten Hauptknoten befindliche Signalladung auf den zweiten Hauptknoten des benachbarten Schaltungsblocks und auf dem zweiten Hauptknoten befindliche Signalladung auf den dritten Hauptknoten desselben Schaltungsblocks verschoben. Gleichzeitig wird auf dem dritten Hauptknoten befindliche Signalladung im letzten Schaltungsblock als Ergebnis für die entsprechende binäre Stelle zum Ausgang des letzten Schaltungsblocks geschoben.

Bei diesem Vorgehen wird bei Durchführung des ersten Grundvorgangs die Summe aus den Größen im ersten Hauptknoten und im zweiten Hauptknoten gebildet, nachfolgend wird die Summe aus dem im zweiten Hauptknoten und im dritten Hauptknoten gespeicherten Größen gebildet. Die wiederholte Anwendung des ersten Grundvorgangs führt dazu, daß der erste Hauptknoten mit einer Null versehen ist. Dabei wird ausgenutzt, daß auf dem ersten Hauptknoten, dem zweiten Hauptknoten und dem dritten Hauptknoten maximal jeweils eine Eins gespeichert sein kann. Die Summe aus erstem Hauptknoten und zweiten Hauptknoten ergibt maximal eine Eins im ersten Hauptknoten und eine Null im zweiten Hauptknoten. Die nachfolgende Summe aus dem zweiten Hauptknoten und dem dritten Hauptknoten ergibt dann eine Null im zweiten Hauptknoten und maximal eine Eins im dritten Hauptknoten. Die anschließende Summe aus erstem Hauptknoten (Eins) und zweitem Hauptknoten (Null) ergibt eine Null im ersten Hauptknoten und eine Eins im zweiten Hauptknoten.

Durch Anwendung des dritten Grundvorgangs auf den dritten Einzelelektron-Transistor wird die auf dem dritten Hauptknoten befindliche Signalladung auf den ersten Hauptknoten des benachbarten Schaltungsblocks, der nach Durchführung des ersten Grundvorgangs, des zweiten Grundvorgangs und des ersten Grundvorgangs sicher eine Null enthält, verschoben. Dadurch ist der dritte Hauptknoten nun mit einer Null versehen. Durch Anwendung des dritten Grundvorgangs auf den zweiten Einzelelektron-Transistor wird die Signalladung vom zweiten Hauptknoten auf den dritten Hauptknoten verschoben, so daß nun der zweite Hauptknoten mit einer Null versehen ist. Durch Anwendung des dritten Grundvorgangs auf den ersten Einzelelektron-Transistor wird die auf dem ersten Hauptknoten befindliche Signalladung, die nach Durchführung des ersten Grundvorgangs, des zweiten Grundvorgangs und des ersten Grundvorgangs auf dem dritten Hauptknoten des benachbarten Schaltungsblocks gespeichert war, auf den zweiten Hauptknoten verschoben. Der erste Hauptknoten ist nach dieser Operation mit einer Null versehen.

Im nächsten Schritt wird für die nächste Stelle der zweiten binären Zahl die Signalladung auf den ersten Hauptknoten aufgebracht, die von dem Produkt dieser Stelle der zweiten binären Zahl mit der entsprechenden Stelle der ersten binären Zahl abhängt. Es wird wie zuvor beschrieben mit allen Stellen der zweiten binären Zahl vorgegangen.

Nach Abarbeiten aller Stellen der zweiten binären Zahl werden durch alternierende Anwendung des zweiten Grundvorgangs und der im Block ausgeführten dritten Grundvorgänge auf den dritten Einzelelektron-Transistor, den zweiten Einzelelektron-Transistor und den ersten Einzelelektron-Transistor die weiteren binären Stellen des Produktes sukzessive am Ausgang erzeugt.

Im folgenden wird die Erfindung anhand von Ausführungsbeispielen, die in den Figuren dargestellt sind, näher erläutert.

| Figur 1 | zeigt eine Schaltungsanordnung mit einem Schaltungsblock, der sechs Einzelelektron-Transistoren aufweist. |
|---|---|
| Figur 2, | die sich aus Figur 2A, 2B und 2C zusammensetzt, zeigt eine Schaltungsanordnung mit drei Schaltungsblöcken, die jeweils sechs Einzelelektron-Transistoren aufweisen. |
| Die Figuren 3a bis 3p | zeigen die in Figur 2 dargestellte Schaltungsanordnung bei der Multiplikation von zwei binären Zahlen. |

Eine Schaltungsanordnung weist sechs Einzelelektron-Transistoren auf, von denen jeweils der i-te-Einzelelektron-Transistor ETi, i = 1, 2, 3, 4, 5, 6, ein Tunnelelement Ti aufweist, das über zwei Tunnelkontakte TKi1, TKi2 mit Anschlüssen verbunden ist und das über eine Gateelektrode Gi kapazitiv beeinflußbar ist. Die Tunnelkontakte TKi1, 2, i = 1,2, 3 des ersten Einzelelektron-Transistors ET1, des zweiten Einzelelektron-Transistors ET2 und des dritten Einzelelektron-Transistors ET3 weisen dabei eine Kapazität von jeweils 0,25 aF auf.

Die ersten Tunnelkontakte TKi1, i = 4, 5 des vierten Einzelelektron-Transistors ET4 und des fünften Einzelelektron-Transistors ET5 weisen dabei eine Kapazität von jeweils 0,3 aF auf. Die zweiten Tunnelkontakte TKi2, i = 4, 5 des vierten Einzelelektron-Transistors und des fünften Einzelelektron-Transistors weisen dabei eine Kapazität von jeweils 0,1 aF auf. Der erste Tunnelkontakt TK61 des sechsten Einzelelektron-Transistors ET6 weist eine Kapazität von 0,4 aF, der zweite Tunnelkontakt TK62 des sechsten Einzelelektron-Transistors ET6 weist eine Kapazität von 0,1 aF auf. Die Gateelektrode Gi, i = 1, 2, 3 des ersten Einzelelektron-Transistors ET1, des zweiten Einzelelektron-Transistors ET2 und des dritten Einzelelektron-Transistors ET3 weist eine Kapazität von jeweils 0,4 aF auf. Die Gateelektrode G4, G5 des vierten Einzelelektron-Transistors ET4 und des fünften Einzelelektron-Transistors ET5 weist eine Kapazität von jeweils 0,2 aF auf. Die Gateelektrode G6 des sechsten Einzelelektron-Transistors ET6 weist eine Kapazität von 0,2 aF auf.

Der erste Einzelelektron-Transistor ET1, der zweite Einzelelektron-Transistor ET2 und der dritte Einzelelektron-Transistor ET3 sind in Reihe zwischen einen ersten Hauptknoten H1 und einen Ausgang A geschaltet. Dabei ist der erste Einzelelektron-Transistor ET1 zwischen den ersten Hauptknoten H1 und einen zweiten Hauptknoten H2 geschaltet. Der zweite Einzelelektron-Transistor ET2 ist zwischen den zweiten Hauptknoten H2 und einen dritten Hauptknoten H3 geschaltet. Der dritte Einzelelektron-Transistor ET3 ist zwischen den dritten Hauptknoten H3 und den Ausgang geschaltet.

Zwischen den zweiten Hauptknoten H2 und einen ersten Versorgungsspannungsanschluß V1 ist der vierte Einzelelektron-Transistor ET4 geschaltet, wobei die Gateelektrode G4 des vierten Einzelelektron-Transistors ET4 mit dem ersten Hauptknoten H1 verbunden ist. Der zweite Hauptknoten H2 ist über einen zweiten Kondensator K2 mit einer Kapazität von 1 aF mit einem zweiten Versorgungsspannungsanschluß V2 verbunden.

Zwischen den dritten Hauptknoten H3 und den ersten Versorgungsspannungsanschluß V1 ist der fünfte Einzelelektron-Transistor ET5 geschaltet, wobei dessen Gateelektrode G5 mit dem zweiten Hauptknoten H2 verbunden ist. Der dritte Hauptknoten H3 ist über einen dritten Kondensator K3 mit einer Kapazität von 1 aF mit einem dritten Versorgungsspannungsanschluß verbunden.

Der erste Hauptknoten H1 ist über einen ersten Kondensator K1 mit einer Kapazität von 0,8 aF mit einem vierten Versorgungsspannungsanschluß V4 verbunden.

Zwischen den ersten Hauptknoten H1 und einen fünften Versorgungsspannungsanschluß V5 ist der sechste Einzelelektron-Transistor ET6 geschaltet, wobei dessen Gateelektrode G6 über einen vierten Kondensator K4 mit einer Kapazität von 0,2 aF mit dem ersten Versorgungsspannungsanschluß V1 verbunden ist.

Da die Gateelektrode G4 des vierten Einzelelektron-Transistors ET4 mit dem ersten Hauptknoten H1 und die Gateelektrode G5 des fünften Einzelelektron-Transistors ET5 mit dem zweiten Hauptknoten H2 verbunden ist, ist die Leitfähigkeit des vierten Einzelelektron-Transistors ET4 bzw. des fünften Einzelelektron-Transistors ET5 von der im ersten Hauptknoten H1 bzw. zweiten Hauptknoten H2 befindlichen Ladungsmenge abhängig, die wiederum einem logischen Wert zugeordnet wird. Daher sind mit Hilfe dieser Schaltungsanordnung Verknüpfungen zwischen Werten, deren zugehörige Ladungsmenge im ersten Hauptknoten H1, im zweiten Hauptknoten H2 und im dritten Hauptknoten H3 gespeichert ist, möglich.

Darüber hinaus kann zwischen dem vierten Kondensator K4 und der Gateelektrode G6 des sechsten Einzelelektron-Transistors ET6 eine einem logischen Wert entsprechende Ladungsmenge gespeichert werden, die die Leitfähigkeit des sechsten Einzelelektron-Transistors ET6 beeinflußt. Auf diese Weise kann der erste Hauptknoten H1 in Abhängigkeit der an der Gateelektrode G6 gespeicherten Größe beladen werden.

Der erste Kondensator K1 und/oder der vierte Kondensator K4 können alternativ als Kapazität, insbesondere als Einzelelektron-Bauelement, Einzelelektron-Transistor oder als komplexere Schaltung mit der angegebenen Gesamtkapazität ausgebildet sein.

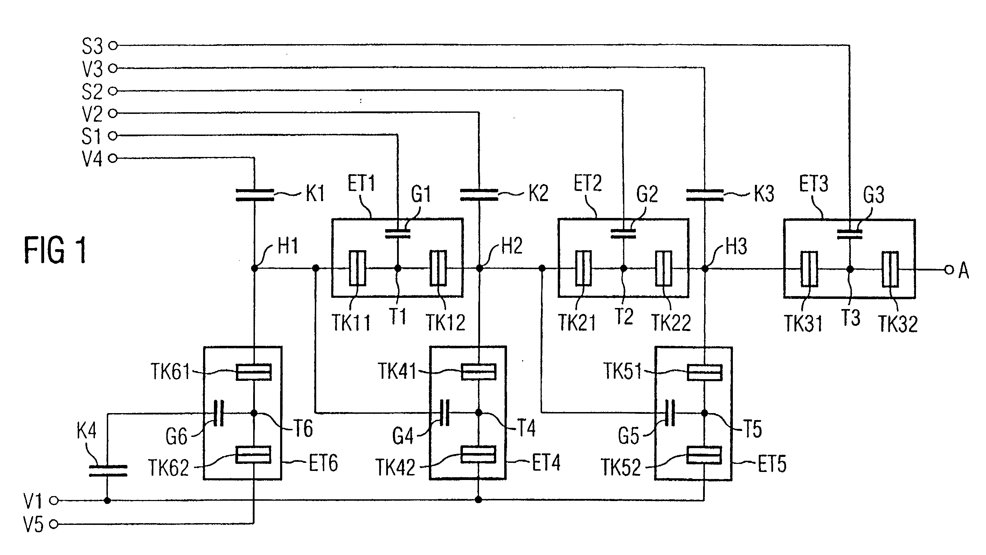

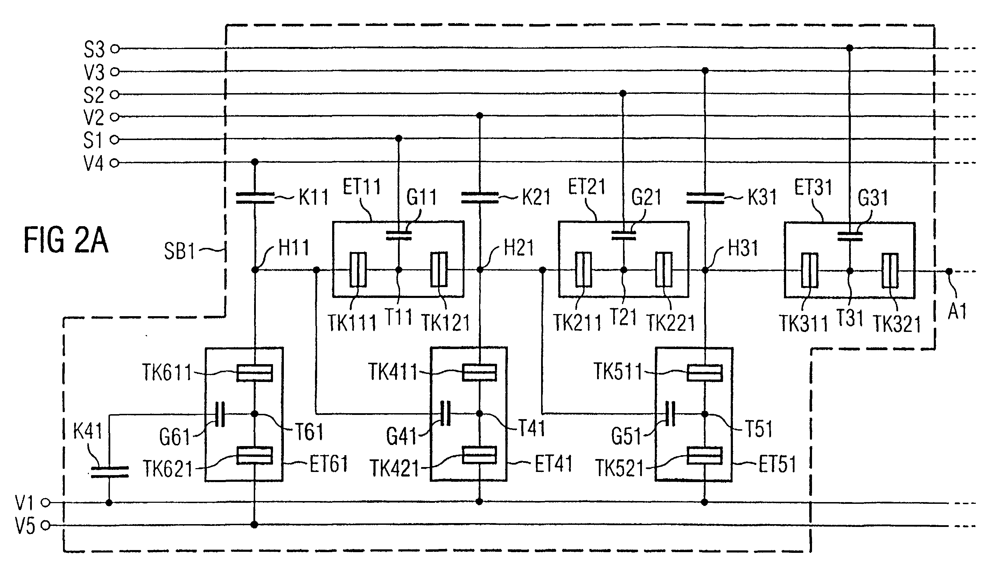

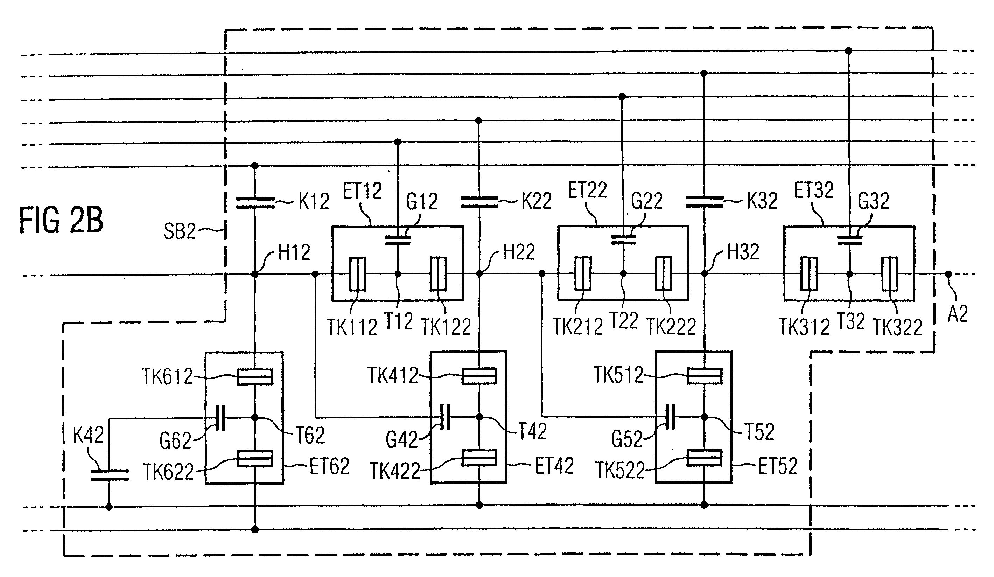

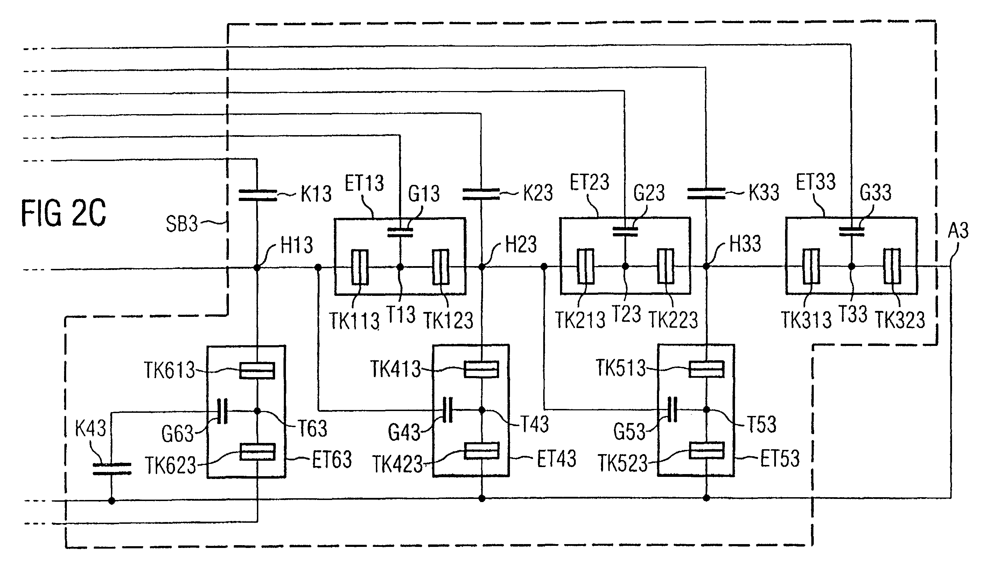

Eine Schaltungsanordnung weist drei Schaltungsblöcke SBj, j = 1, 2, 3 auf, von denen jeder analog wie die anhand von Figur 1 beschriebene Schaltungsanordnung aufgebaut ist (siehe Figur 2). Jeder der Schaltungsblöcke SBj weist sechs Einzelelektron-Transistoren ETij, i = 1 bis 6, j = 1 bis 3 auf, die entsprechend wie anhand von Figur 1 geschildert verschaltet sind. Analog wie in Figur 1 weist jeder der Einzelelektron-Transistoren ETij, i = 1 bis 6, j = 1 bis 3 ein Tunnelelement Tij, Tunnelkontakte TKikj und eine Gateelektrode Gij, i = 1 bis 6, j = 1 bis 3, k = 1, 2 auf.

Der erste Einzelelektron-Transistor ET1j, der zweite Einzelelektron-Transistor ET2j und der dritte Einzelelektron-Transistor ET3j sind über einen zweiten Hauptknoten H2j und einen dritten Hauptknoten H3j zwischen einen ersten Hauptknoten H1j und einen Ausgang Aj geschaltet. Der Ausgang Aj eines Schaltungsblocks SBj ist dabei mit dem ersten Hauptknoten H1j+1 des benachbarten Schaltungsblock SBj+1, j = 1, 2, verbunden. Der Ausgang A3 des dritten Schaltungsblocks SB3 bildet den Ausgang der Schaltungsanordnung.

Die Gateelektrode G1j des ersten Einzelelektron-Transistors ET1j ist jeweils mit einem ersten Steuerspannungsanschluß ST1 verbunden. Die Gateelektrode G2j des zweiten Einzelelektron-Transistors ET2j ist jeweils mit einem zweiten Steuerspannungsanschluß ST2 verbunden. Die Gateelektrode G3j des dritten Einzelelektron-Transistors ET3j ist jeweils mit einem dritten steuerspannungsanschluß ST3 verbunden. Über einen ersten Kondensator K1j ist der erste Hauptknoten H1j jeweils mit einem vierten Versorgungsspannungsanschluß VS4 verbunden. Über einen zweiten Kondensator K2j ist der zweite Hauptknoten H2j jeweils mit einem zweiten Versorgungsspannungsanschluß VS2 verbunden. Über einen dritten Kondensator K3j ist der dritten Hauptknoten H3j jeweils mit einem dritten Versorgungsspannungsanschluß VS3 verbunden. Die Gateelektrode G4j des vierten Einzelelektron-Transistors ET4j ist jeweils mit dem ersten Hauptknoten H1j verbunden. Die Gateelektrode G5j des fünften Einzelelektron-Transistors ET5j ist jeweils mit dem zweiten Hauptknoten H2j verbunden. Der vierte Einzelelektron-Transistor ET4j ist jeweils zwischen den zweiten Hauptknoten H2j und einen ersten Versorgungsspannungsanschluß VS1 geschaltet. Der fünfte Einzelelektron-Transistor ET5j ist jeweils zwischen den dritten Hauptknoten H3j und den ersten Versorgungsspannungsanschluß VS1 geschaltet.

Der sechste Einzelelektron-Transistor ET6j ist jeweils zwischen den ersten Hauptknoten H1j und einen fünften Versorgungsspannungsanschluß VS5 geschaltet. Die Gateelektrode G6j des sechsten Einzelelektron-Transistors ET6j ist jeweils über einen vierten Kondensator K4j mit dem ersten Versorgungsspannungsanschluß VS1 verbunden.

Der Ausgang A3 des dritten Schaltungsblockes SB3 ist mit dem ersten Versorgungsspannungsanschluß VS1 verbunden.

Mit Ausnahme des zweiten Tunnelkontaktes TK323 des dritten Einzelelektron-Transistors ET33 des dritten Schaltungsblocks SB3 entsprechen die elektrischen Dimensionierungen aller Merkmale denjenigen in Figur 1. Die Kapazität des zweiten Tunnelkontaktes TK323 beträgt 0,2 aF (siehe Figur 2).

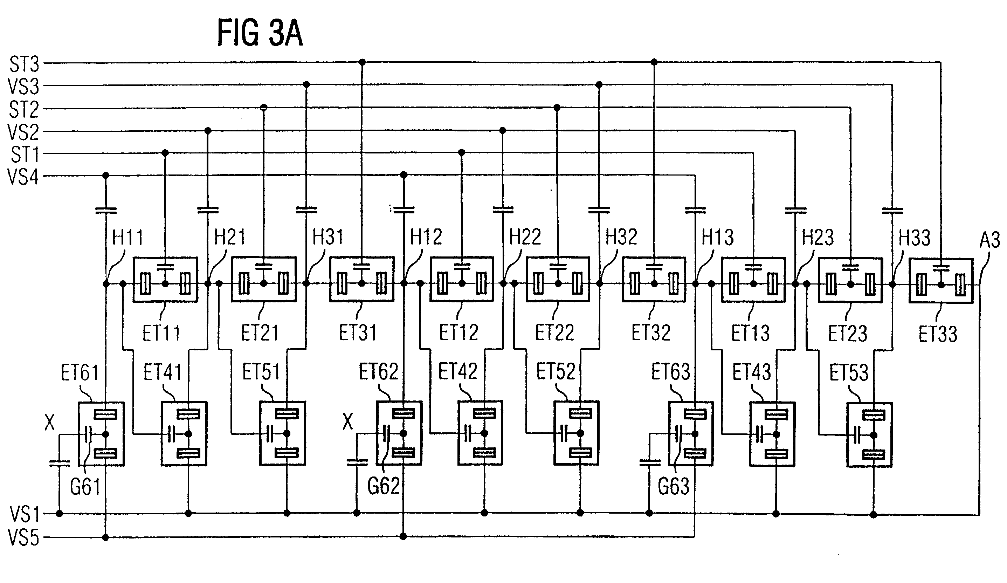

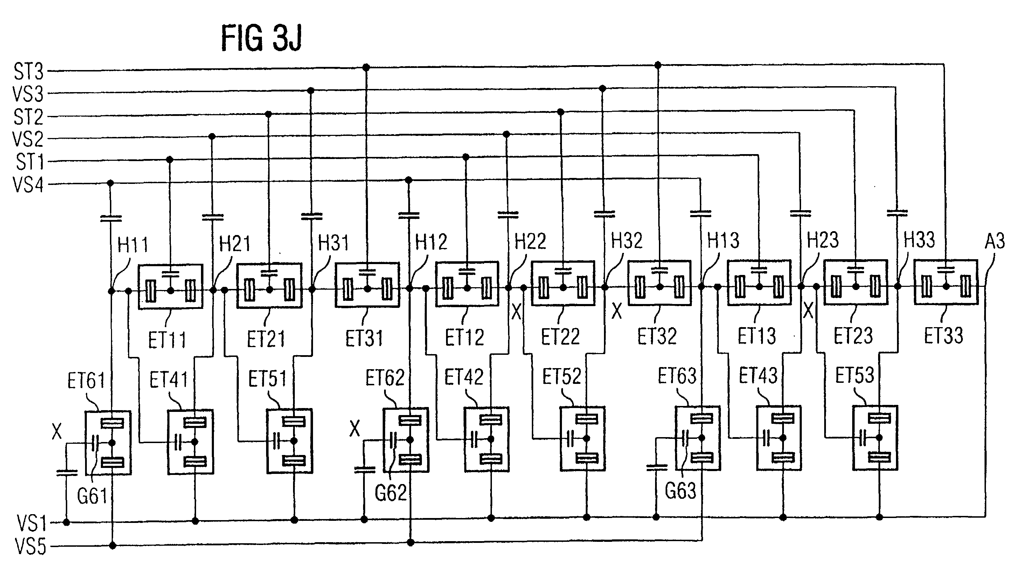

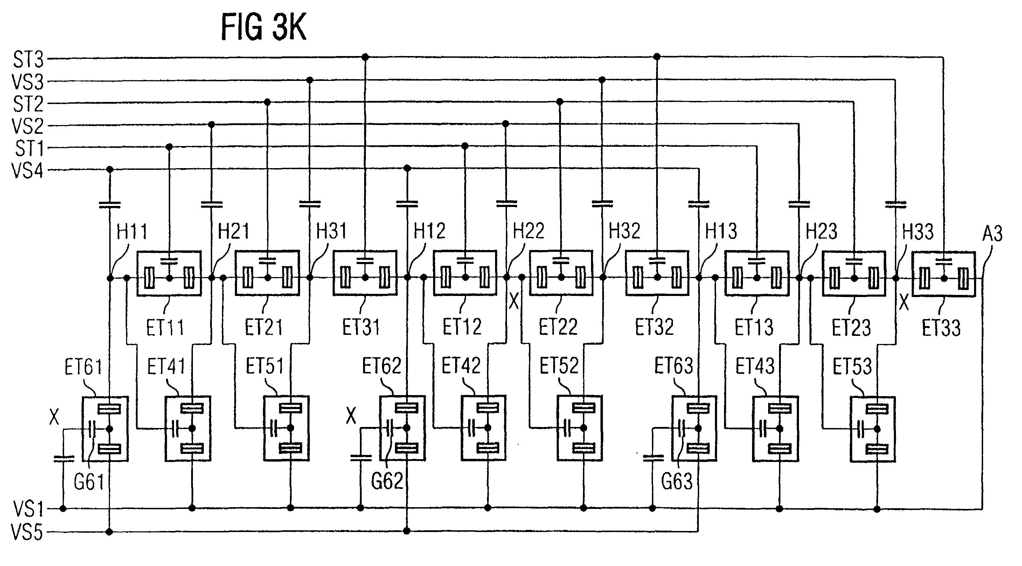

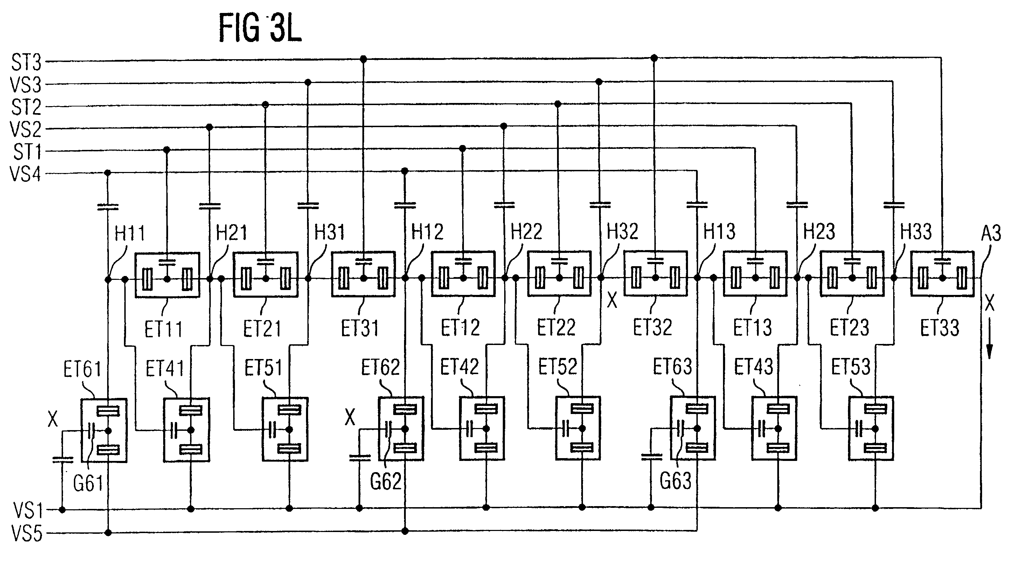

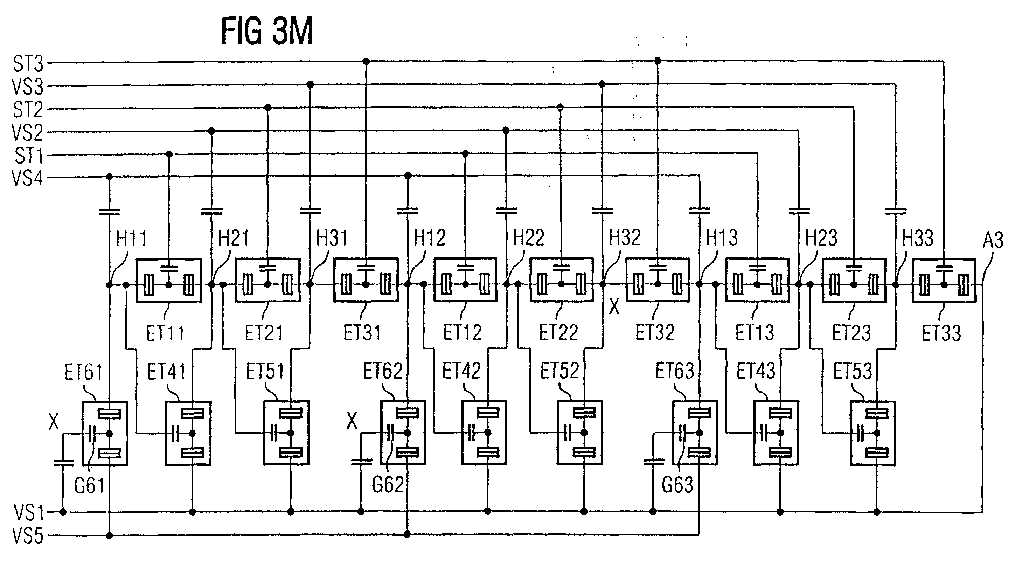

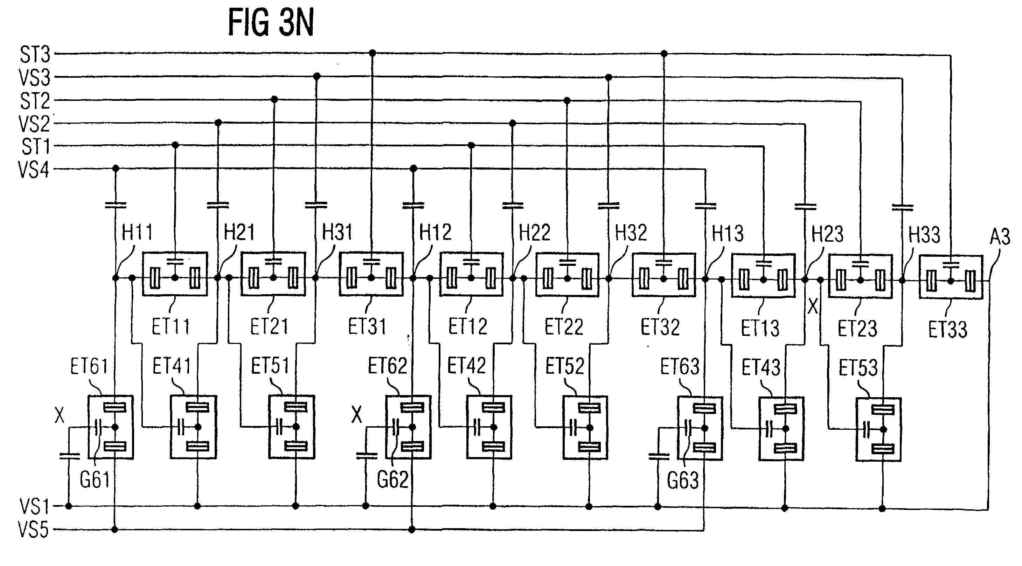

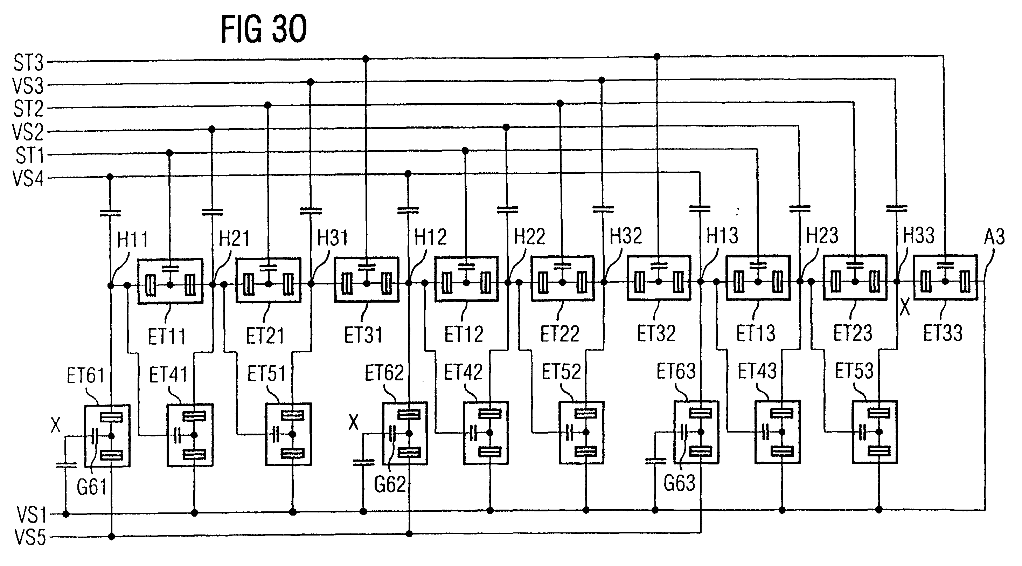

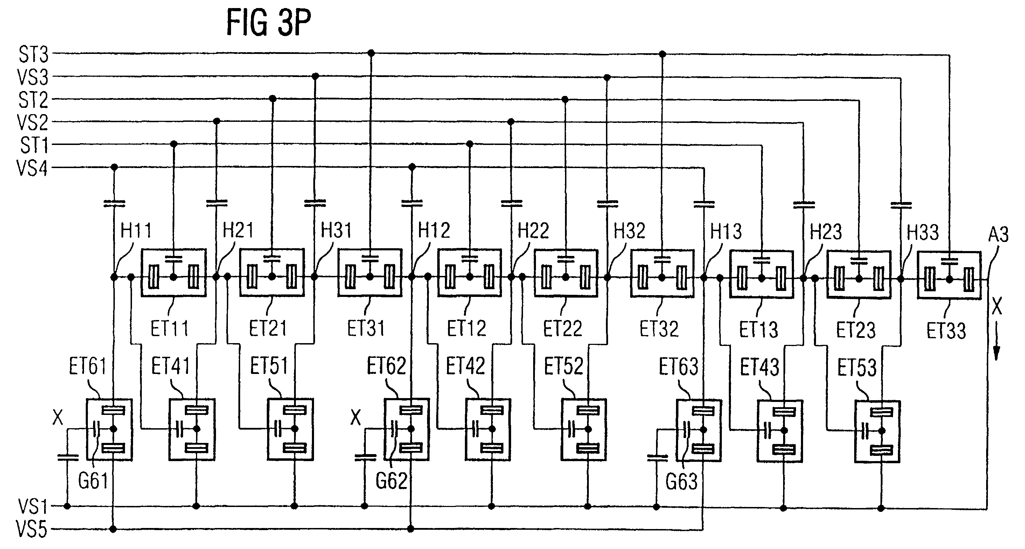

Die anhand von Figur 2 geschilderte Schaltungsanordnung ist zur Multiplikation von zwei dreistelligen Binärzahlen geeignet. Ein Beispiel für die Multiplikation zwei dreistelliger Binärzahlen wird im folgenden anhand der Figuren 3a bis 3p erläutert. Dabei wird der Begriff "Ladungsträger" für Überschußladungsträger verwendet.

Die Stellen einer ersten Binärzahl werden an die Gateelektrode G6j des sechsten Einzelelektron-Transistors ET6 in Form einer Signalladung, die dem Wert 1 oder 0 entspricht, angelegt. Für den Wert 1 wird ein Elektron, für den Wert Null wird kein Elektron an der Gateelektrode G6j wirksam. Die Multiplikation mit den Stellen der zweiten Binärzahl erfolgt durch Beaufschlagen des fünften Versorgungsspannungsanschlusses VS5 mit einer dem Wert der entsprechenden Stelle, Null oder Eins, entsprechenden Spannung. Die verschiedenen Stellen der zweiten Binärzahl werden im Laufe des Verfahrens sukzessive berücksichtigt. Die Spannungen werden so bemessen, daß für den Wert Eins der zweiten Binärzahlstelle über den sechsten Einzelelektron-Transistor ET6j ein Elektron auf den ersten Hauptknoten H1j fließt, falls an der Gateelektrode G6j der Wert Eins der ersten Binärzahlstelle wirksam ist. Für den Wert Null der zweiten Binärzahlstelle wird die Spannung so bemessen, daß kein Elektron über den sechsten Einzelelektron-Transistor ET6j auf den ersten Hauptknoten H1j fließt.

Zur Multiplikation ist eine Kombination der folgenden Schritte erforderlich:

1. Multiplikation der Stellen der ersten Binärzahl mit den Stellen der zweiten Binärzahl.

2. Summe der am ersten Hauptknoten H1j und am zweiten Hauptknoten H2j gespeicherten Werte.

3. Summe der im zweiten Hauptknoten H2j und dritten Hauptknoten H3j gespeicherten Werte.

4. Verschieben des Wertes von dem ersten Hauptknoten H1j auf den zweiten Hauptknoten H2j.

5. Verschieben eines Wertes von einem Hauptknoten H1j, H2j, H3j auf den benachbarten Speicherknoten H2j, H3j, H1j+1 über den dazwischen angeordneten Einzelelektron-Transistor ET1j, ET2j, ET3j.

In dem ersten Schritt wird zur Multiplikation mit dem Wert 0 der Stelle der zweiten Binärzahl eine Operation 01 und zur Multiplikation mit dem Wert 1 der Stelle der zweiten Binärzahl eine Operation 02 durchgeführt.

Der zweite Schritt, der in dieser Beschreibung auch erster Grundvorgang genannt wird, setzt sich aus drei Operationen O3, O4 und O5 zusammen. In Operation O3 fließen auf den ersten Hauptknoten H1j befindliche Ladungsträger auf den zweiten Hauptknoten H2j, sofern sich auf dem zweiten Hauptknoten H2j zuvor keine Ladungsträger befinden. Befinden sich auf dem zweiten Hauptknoten H2j Ladungsträger, so fließen auf dem ersten Hauptknoten H1j befindliche Ladungsträger bei der Operation O3 auf das Tunnelelement T1j des ersten Einzelelektron-Transistors ET1j.

In Operation O4 fließen auf dem Tunnelelement T1j des ersten Einzelelektron-Transistors ET1j befindliche Ladungsträger auf den ersten Hauptknoten H1j.

In Operation O5 fließen auf dem zweiten Hauptknoten H2j befindliche Ladungsträger über den vierten Einzelelektron-Transistor ET4j ab, falls auf dem ersten Hauptknoten H1j sich Ladungsträger befinden.

Der dritte Schritt, der in dieser Anmeldung auch als zweiter Grundvorgang bezeichnet wird, erfordert ebenfalls drei Operationen O6, O7, O8.

In Operation O6 fließen auf dem zweiten Hauptknoten H2j befindliche Ladungsträger auf den dritten Hauptknoten H3j, sofern sich auf dem dritten Hauptknoten H3j zuvor keine Ladungsträger befinden und auf das Tunnelelement T2j des zweiten Einzelelektron-Transistors ET2j, sofern sich auf dem dritten Hauptknoten H3j Ladungsträger befinden.

In Operation O7 fließen Ladungsträger von dem Tunnelelement T2j des zweiten Einzelelektron-Transistors ET2j auf den zweiten Hauptknoten H2j.

In Operation O8 fließen auf dem dritten Hauptknoten H3j befindliche Ladungsträger über den fünften Einzelelektron-Transistor ET5j ab, falls sich auf dem zweiten Hauptknoten H2j Ladungsträger befinden.

In dem vierten Schritt werden in einer Operation O9 auf dem ersten Hauptknoten H1j befindliche Ladungsträger auf den zweiten Hauptknoten H2j verschoben. Da auf einem der beiden Hauptknoten der Wert Null gespeichert ist, entspricht das der Anwendung des ersten Grundvorgangs.

Der fünfte Schritt, der in dieser Anmeldung auch als dritter Grundvorgang bezeichnet wird, enthält drei mögliche Operationen O10, O11, 012 entsprechend der Anwendung des dritten Grundvorgangs auf den dritten Einzelelektron-Transistor ET3j, der Anwendung des dritten Grundvorgangs auf den zweiten Einzelelektron-Transistor ET2j und der Anwendung des dritten Grundvorgangs auf den ersten Einzelelektron-Transistor ET1j.

In Operation 010 wird ein Ladungsträger von dem dritten Hauptknoten H3j auf den ersten Hauptknoten H1j+1 des benachbarten Schaltungsblockes SBj+1, j = 1, 2 oder auf den Ausgang A des dritten Schaltungsblockes SB3 verschoben.

In Operation O11 werden Ladungsträger von dem zweiten Hauptknoten H2j auf den dritten Hauptknoten H3j verschoben.

In Operation O12 werden Ladungsträger von dem ersten Hauptknoten H1j auf den zweiten Hauptknoten H2j verschoben.

Zur Durchführung der Operationen On, n = 1 bis 12, werden die Versorgungsspannungsanschlüsse VS1, VS2, VS3, VS4, VS5 und die Steuerspannungsanschlüsse ST1, ST2, ST3 jeweils mit den Spannungspegeln beaufschlagt, die Tabelle 1 zu entnehmen sind.

Tabelle 1

| Operation | VS1/ mV | VS5/ mV | VS4/ mV | ST1/ mV | VS2/ mV | ST2/ mV | VS3/ mV | ST3/ mV |
|---|---|---|---|---|---|---|---|---|
| 01 | 0 | -170 | -70 | -90 | 30 | -50 | -60 | -90 |
| 02 | 0 | -100 | 120 | 40 | 40 | 30 | 30 | 40 |
| 03 | 0 | -170 | -80 | 30 | 0 | -40 | -60 | -80 |
| 04 | 0 | -150 | -50 | -10 | -10 | -40 | -50 | -60 |
| 05 | 0 | -170 | -60 | -70 | -90 | -70 | 0 | -100 |
| 06 | 0 | -160 | -50 | -60 | -50 | 120 | 30 | -100 |
| 07 | 0 | -170 | -70 | -80 | -50 | -70 | -40 | -80 |
| 08 | 0 | -170 | -70 | -80 | -80 | -80 | -90 | -60 |
| 09 | 0 | -170 | -80 | 30 | 0 | -40 | -60 | -80 |
| 010 | 0 | -130 | -20 | -40 | -4 | -49 | -125 | 19 |
| 011 | 0 | -160 | -50 | -60 | -50 | 120 | 30 | -100 |
| 012 | 0 | -170 | -80 | 30 | 0 | -40 | -60 | -80 |

In den Figuren 3a bis 3p sind jeweils nur die Bezugszeichen eingezeichnet, die für die Erläuterung des Verfahrens wichtig sind. Durch x ist in den Figuren 3a bis 3p gekennzeichnet, wo ein Elektron gespeichert ist.

Zur Multiplikation der ersten Binärzahl 110 mit der zweiten Binärzahl 111 wird an die Gateelektrode G6j der sechsten Einzelelektron-Transistoren ET6j jeweils eine Signalladung entsprechend einer Stelle der ersten Binärzahl angelegt. An die Gateelektrode G61 wird ein Elektron entsprechend einer Eins, an die Gateelektrode G62 ein Elektron entsprechend einer Eins, an die Gateelektrode G63 kein Elektron entsprechend einer Null angelegt (siehe Figur 3a).

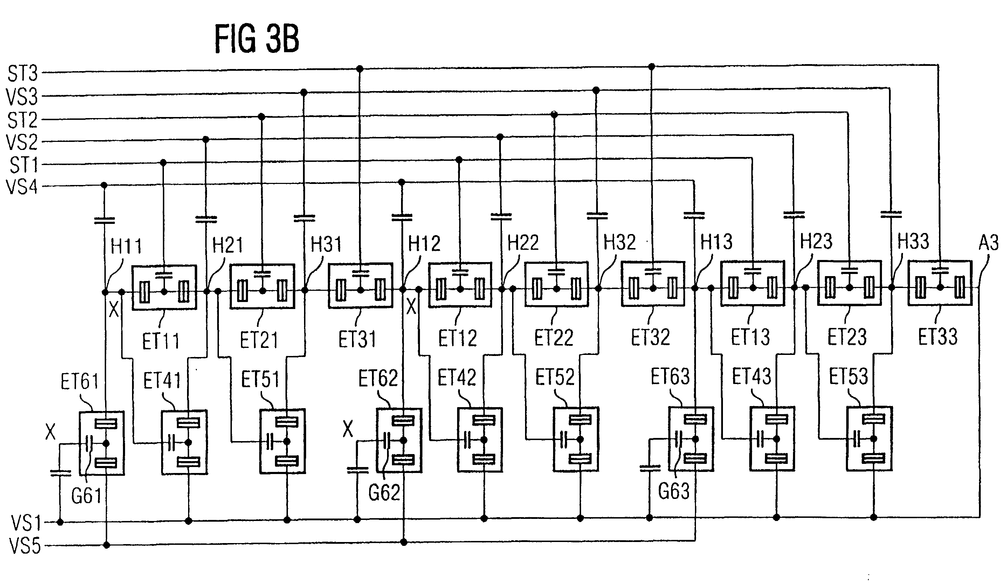

Es folgt die Multiplikation mit der ersten Stelle der zweiten Binärzahl, die den Wert Eins hat. Diese Multiplikation wird durch Anwendung der Operation O2 durchgeführt. Dadurch gelangt auf den ersten Hauptknoten H11 und den ersten Hauptknoten H12 jeweils ein Elektron (siehe Figur 3b).

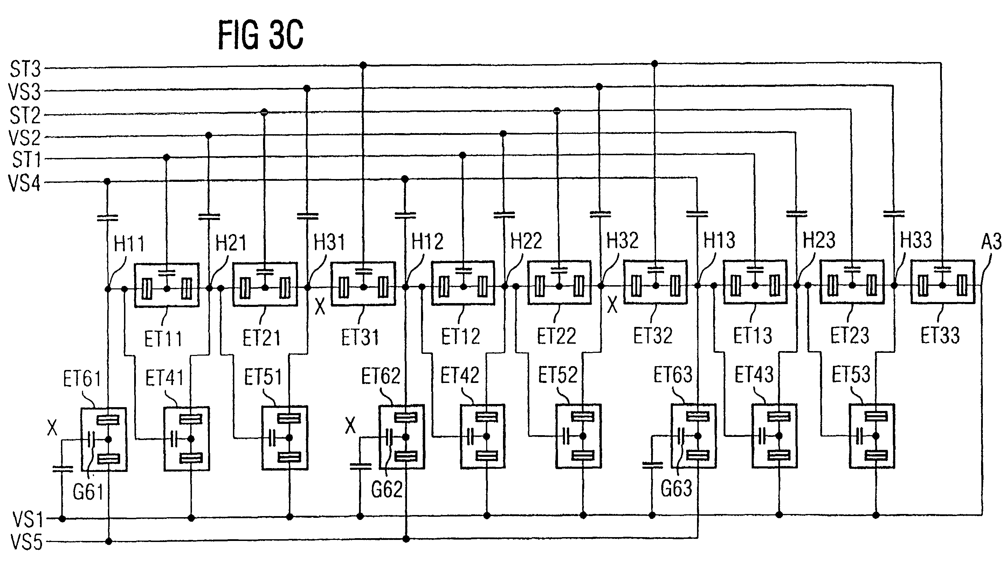

Durch sukzessive Anwendung des ersten Grundvorgangs (O3, O4, O5), des zweiten Grundvorgangs (O6, O7, O8) und der Operation 09 gelangt ein Elektron von dem ersten Hauptknoten H11 auf den dritten Hauptknoten H31 und von dem ersten Hauptknoten H12 auf den dritten Hauptknoten H32 (siehe Figur 3c).

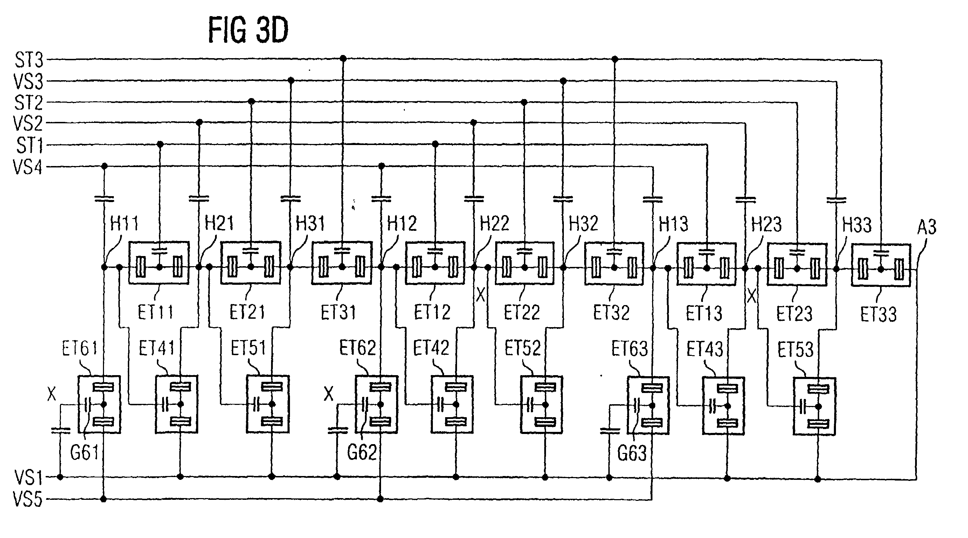

Durch Anwendung der Operationen O10, O11, O12 wird ein Elektron von dem dritten Hauptknoten H31 auf den zweiten Hauptknoten H22 und ein Elektron von dem dritten Hauptknoten H32 auf den zweiten Hauptknoten H23 verschoben. Gleichzeitig wird detektiert, welche Ladung über den Ausgang A3 fließt. Entsprechend dem Wert Null der Stelle mit Wertigkeit $2^0$ des Ergebnisses fließt kein Strom über den Ausgang A3 (siehe Figur 3d).

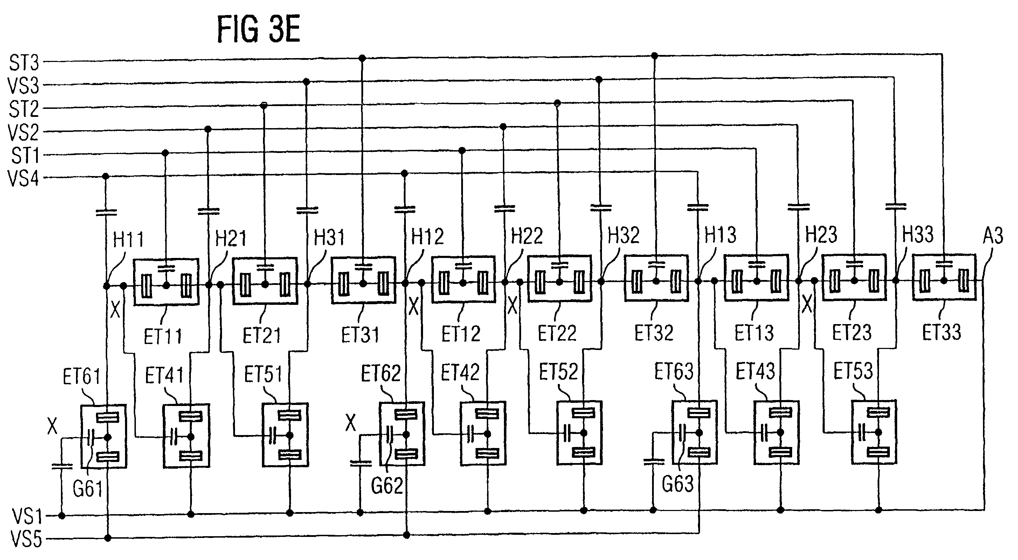

Durch Anwendung der Operation O2 wird die an der Gateelektrode G6j des sechsten Einzelelektron-Transistors ET6j gespeicherte Stelle der ersten Binärzahl jeweils mit der zweiten Stelle der zweiten Binärzahl, die den Wert Eins hat, multipliziert. Dadurch gelangen auf den ersten Hauptknoten H11 und den zweiten Hauptknoten H12 jeweils ein Elektron (siehe Figur 3e).

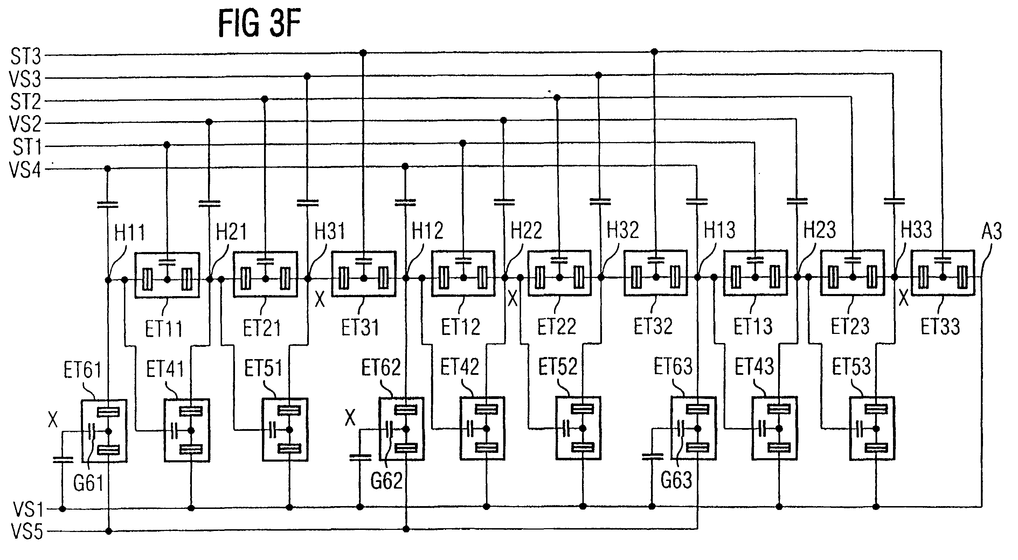

Durch Anwendung des ersten Grundvorgangs (Operation O3, O4, O5), des zweiten Grundvorgangs (Operation 06, 07, 08) und Operation 09 wird die in Figur 3f dargestellte Situation erzielt, in der auf den dritten Hauptknoten H31, dem zweiten Hauptknoten H22 und dem dritten Hauptknoten H33 jeweils ein Elektron gespeichert ist.

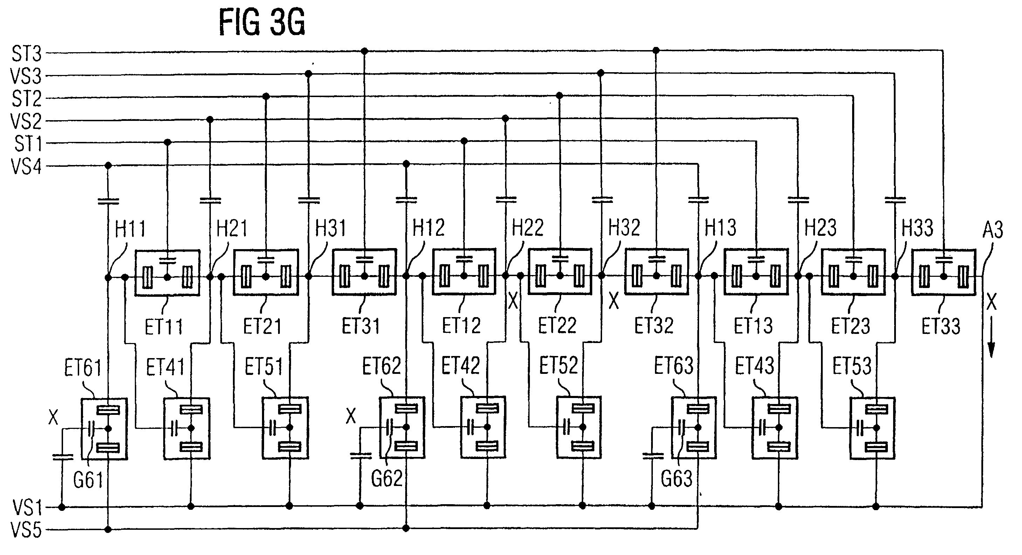

Nach Durchführung der Operationen O10, O11, O12 befindet sich ein Elektron auf dem zweiten Hauptknoten H22 und ein Elektron auf dem dritten Hauptknoten H33. Über den Ausgang A3 ist ein Elektron geflossen, entsprechend der Stelle mit Wertigkeit $2^1$ des Ergebnisses (siehe Figur 3g).

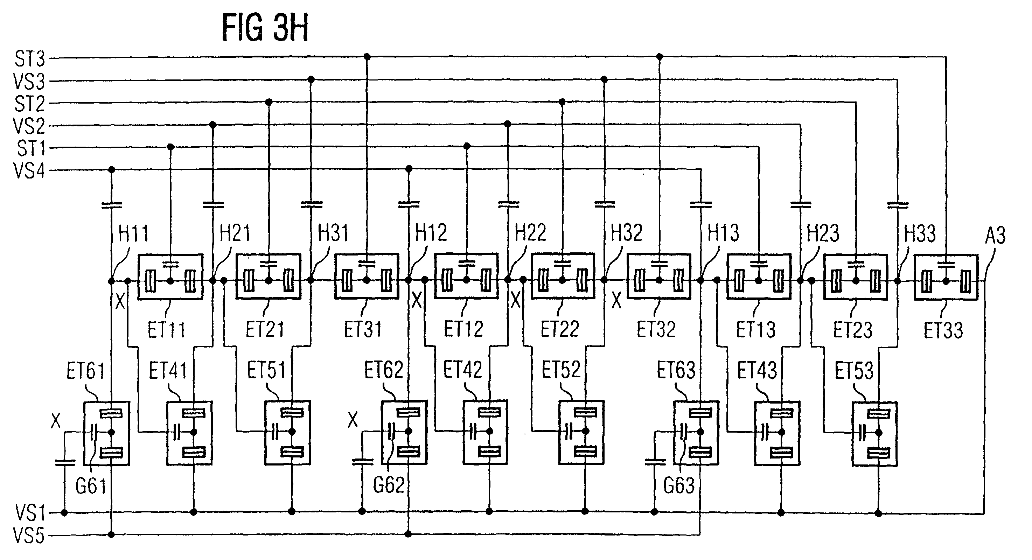

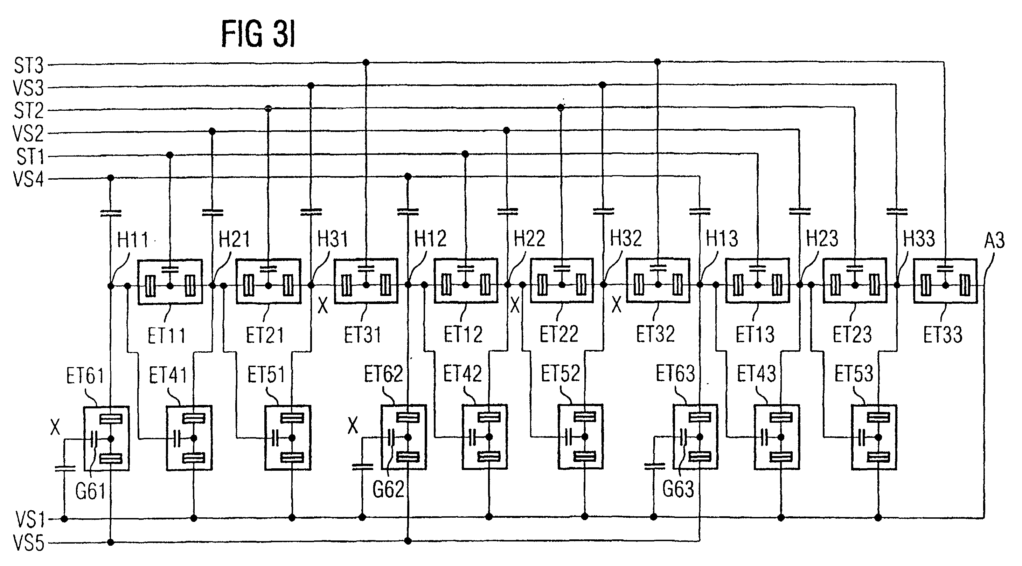

Durch Anwendung der Operation O2 werden die Stellen der ersten Binärzahl jeweils mit der dritten Stelle der zweiten Binärzahl, die den Wert Eins hat, multipliziert. Dadurch befindet sich auf dem ersten Hauptknoten H11, dem ersten Hauptknoten H12, dem zweiten Hauptknoten H22 und dem dritten Hauptknoten H32 jeweils ein Elektron (siehe Figur 3h).

Durch Anwendung des ersten Grundvorgangs und des zweiten Grundvorgangs (Operationen O3, O4, O5, O6, O7, O8) und Operation 09 befindet sich auf dem dritten Hauptknoten H31, dem zweiten Hauptknoten H22 und dem dritten Hauptknoten H32 jeweils ein Elektron (siehe Figur 3i).

Durch Anwendung der Operationen O10, O11, O12 befindet sich auf dem zweiten Hauptknoten H22, dem dritten Hauptknoten H32 und dem zweiten Hauptknoten H23 jeweils ein Elektron (siehe Figur 3j). Über den Ausgang A3 ist bei diesem Vorgang kein Elektron geflossen, entsprechend dem Wert Null der Stelle mit Wertigkeit $2^2$ des Ergebnisses.

Durch Anwenden des zweiten Grundvorgangs (Operation O6, O7, O8) befindet sich auf dem zweiten Hauptknoten H22 und dem dritten Hauptknoten H33 jeweils ein Elektron (siehe Figur 3k).

Durch Anwenden der Operation O10, O11, O12 befindet sich auf dem dritten Hauptknoten H32 ein Elektron. Gleichzeitig fließt über den Ausgang A3 ein Elektron entsprechend dem Wert 1 der Stelle mit Wertigkeit $2^3$ des Ergebnisses (siehe Figur 31).

Durch Anwenden des zweiten Grundvorganges (Operation O6, O7, O8) befindet sich auf dem dritten Hauptknoten H32 ein Elektron (siehe Figur 3m).

Durch Anwenden der Operationen O10, O11, O12 befindet sich auf dem zweiten Hauptknoten H23 ein Elektron. Gleichzeitig fließt über den Ausgang A3 kein Elektron, entsprechend dem Wert Null der Stelle mit Wertigkeit $2^4$ des Ergebnisses (siehe Figur 3n).

Anschließend wird der zweite Grundvorgang (Operation O6, O7, O8) durchgeführt, so daß sich auf dem dritten Hauptknoten H33 ein Elektron befindet (siehe Figur 3o).

Durch Anwendung der Operationen O10, O11, O12 fließt über den Ausgang A3 ein Elektron entsprechend dem Wert 1 der Stelle mit Wertigkeit $2^5$ des Ergebnisses. Das Ergebnis der Multiplikation lautet somit 101010.

Es sind zahlreiche Varianten der Erfindung möglich. Insbesondere kann der vierte Kondensator K4J durch eine komplexere Schaltung, ein Einzelelektron-Bauelement oder einen Einzelelektron-Transistor ersetzt werden.

Die Detektion des Ergebnisses durch Messung des Stroms über den dritten Einzelelektron-Transistor ET33 kann auf verschiedene Weise erfolgen. Die dem Ergebnis entsprechende Signalladung kann in ein Schieberegister eingelesen werden oder mit Hilfe eines als Elektrometerverstärker verwendeten Einzelelektron-Transistors, dessen Gateelektrode mit dem dritten Hauptknoten H33 verbunden ist, ausgelesen werden. Eine Verbindung des Ausganges A3 mit der ersten Versorgungsspannung VS1 ist nicht unbedingt erforderlich.

Das Verfahren kann auch mit anderen Spannungen als den angegebenen Werten durchgeführt werden. Insbesondere kann durch eine kompliziertere Schaltung eine vom Wert der entsprechenden Stelle der zweiten Binärzahl abhängige Ladungsmenge auf den Anschluß des sechsten Einzelelektron-Transistors ET6J gegeben werden.

**Patentansprüche**

1.  Schaltungsanordnung mit Einzelelektron-Bauelementen,

    -   bei der ein Schaltungsblock mit einem ersten Einzelelektron-Transistor (ET1), einem zweiten Einzelelektron-Transistor (ET2), einem dritten Einzelelektron-Transistor (ET3), einem vierten Einzelelektron-Transistor (ET4) und einem fünften Einzelelektron-Transistor (ET5) vorgesehen ist,

    -   bei der der erste Einzelelektron-Transistor (ET1) zwischen einen ersten Hauptknoten (H1) und einen zweiten Hauptknoten (H2), der zweite Einzelelektron-Transistor (ET2) zwischen den zweiten Hauptknoten (H2) und einen dritten Hauptknoten (H3) und der dritte Einzelelektron-Transistor (ET3) zwischen den dritten Hauptknoten (H3) und einen Ausgang (A) geschaltet sind,

    -   bei der der vierte Einzelelektron-Transistor (ET4) zwischen den zweiten Hauptknoten (H2) und einen ersten Versorgungsspannungsanschluß (V1) und der fünfte Einzelelektron-Transistor (ET5) zwischen den dritten Hauptknoten (H3) und den ersten Versorgungsspannungsanschluß (V1) geschaltet ist,

    -   bei der der zweite Hauptknoten (H2) kapazitiv mit einem zweiten Versorgungsspannungsanschluß (V2) und der dritte Hauptknoten (H3) kapazitiv mit einem dritten Versorgungsspannungsanschluß (V3) verbunden sind,

    -   bei der die Gateelektrode (G1) des ersten Einzelelektron-Transistors (ET1) mit einem ersten Steuerspannungsanschluß (S1), die Gateelektrode (G2) des zweiten Einselelektron-Transistors (ET2) mit einem zweiten Steuerspannungsanschluß (S2) und die Gateelektrode (G3) des dritten Einzelelektron-Transistors (ET3) mit einem dritten Steuerspannungsanschluß (S3) verbunden ist,

- bei der die Gateelektrode (G4) des vierten Einzelelektron-Transistors (ET4) mit dem ersten Hauptknoten (H1) und die Gateelektrode (G5) des fünften Einzelelektron-Transistors (ET5) mit dem zweiten Hauptknoten (H2) verbunden ist,

- bei der der erste Hauptknoten (H1) kapazitiv mit einem vierten Versorgungsspannungsanschluß (V4) verbunden ist und der erste Hauptknoten (H1) über ein kapazitives Element mit einem fünften Versorgungsspannungsanschluß (V5) verbunden ist, wobei sich der fünfte Versorgungsspannungsanschluß (V5) von dem ersten Versorgungsspannungsanschluß (V1) unterscheidet.

2. Schaltungsanordnung nach Anspruch 1,
bei der der zweite Hauptknoten (H2) und der dritte Hauptknoten (H3) jeweils über einen Kondensator (K2, K3) mit dem zweiten Versorgungsspannungsanschluß (V2) bzw. dem dritten Versorgungsspannungsanschluß (V3) verbunden sind.

3. Schaltungsanordnung nach Anspruch 1 oder 2,
bei der ein sechster Einzelelektron-Transistor (ET6) vorgesehen ist, der zwischen den ersten Hauptknoten (H1) und den fünften Versorgungsspannungsanschluß (V5) geschaltet ist.

4. Schaltungsanordnung nach Anspruch 3,
bei der die Gateelektrode (G6) des sechsten Einzelelektron-Transistors (ET6) kapazitiv mit der ersten Versorgungsspannung (V1) verbunden ist.

5. Schaltungsanordnung nach Anspruch 4,

- bei der die Gateelektrode (G6) des sechsten Einzelelektron-Transistors (ET6) über einen Kondensator (K4) mit dem ersten Versorgungsspannungsanschluß (V1) verbunden ist,

- bei der der erste Hauptknoten (H1) über einen Kondensator (K1) mit dem vierten Versorgungsspannungsanschluß (V4) verbunden ist.

6. Schaltungsanordnung nach einem der Ansprüche 1 bis 5,
bei der mehrere Schaltungsblöcke vorgesehen sind, die wie der erstgenannte Schaltungsblock aufgebaut und die in Reihe verschaltet sind, so daß der Ausgang (A) eines der Schaltungsblöcke mit dem ersten Hauptknoten (H1) des benachbarten Schaltungsblocks verbunden ist.

7. Verfahren zum Betrieb einer Schaltungsanordnung nach einem der Ansprüche 1 bis 6,

- bei dem auf den ersten Hauptknoten (H1), den zweiten Hauptknoten (H2) und den dritten Hauptknoten (H3) in Abhängigkeit des logischen Wertes einer Größe Überschußladungsträger aufgebracht werden,

- bei dem eine logische Verknüpfung der logischen Werte durch eine Kombination von Grundvorgängen erfolgt,

- bei dem in einem ersten Grundvorgang auf dem ersten Hauptknoten (H1) befindliche Überschußladungsträger auf den zweiten Hauptknoten (H2) fließen, sofern sich auf dem zweiten Hauptknoten (H2) zuvor keine Überschußladungsträger befinden und auf dem ersten Hauptknoten (H1) befindliche Überschußladungsträger auf das Tunnelelement des ersten Einzelelektron-Transistor (ET1) fließen, sofern sich auf dem zweiten Hauptknoten (H2) Überschußladungsträger befinden,

- bei dem nachfolgend auf dem Tunnelübergang des ersten Einzelelektron-Transistors (ET1) befindliche Überschußladungsträger auf den ersten Hauptknoten (H1) fließen,

- bei dem nachfolgend auf dem zweiten Hauptknoten (H2) befindliche Überschußladungsträger über den vierten Einzelelektron-Transistor (ET4) nur dann abfließen, wenn sich auf dem ersten Hauptknoten (H1) Uberschußladungsträger befinden,

- bei dem in einem zweiten Grundvorgang auf dem zweiten Hauptknoten (H2) befindliche Überschußladungsträger auf den dritten Hauptknoten (H3) fließen, sofern sich auf dem dritten Hauptknoten (H3) zuvor keine Überschußladungsträger befinden und auf dem zweiten Hauptknoten (H2) befindliche Überschußladungsträger auf das Tunnelelement des zweiten Einzelelektron-Transistors (ET2) fließen, sofern sich auf dem dritten Hauptknoten (H3) Überschußladungsträger befinden,

- bei dem nachfolgend auf dem Tunnelelement des zweiten Einzelelektron-Transistors (ET2) befindliche Überschußladungsträger auf den zweiten Hauptknoten (H2) fließen,

- bei dem auf dem dritten Hauptknoten (H3) befindliche Überschußladungsträger über den fünften Einzelelektron-Transistor (ET5) nur dann abfließen, wenn sich auf dem zweiten Hauptknoten (H2) Überschußladungsträger befinden,

- bei dem in einem dritten Grundvorgang Überschußladungsträger von einem Hauptknoten auf den benachbarten Hauptknoten durch Ansteuerung des zwischen den benachbarten Hauptknoten befindlichen Einzelelektron-Transistors verschoben werden.

8. Verfahren nach Anspruch 7 in Verbindung mit Anspruch 3 und Anspruch 6,

- bei dem zur Multiplikation einer ersten Binärzahl mit einer zweiten Binärzahl die Stellen der ersten Binärzahl an die Gateelektrode (G6) des sechsten Einzelelektron-Transistors (ET6) der benachbarten Schaltungsblöcke angelegt werden,

- bei dem nachfolgend sukzessive für alle Stellen der zweiten Binärzahl die Stelle der zweiten Binärzahl an den ersten Versorgungsspannungsanschluß (V1) angelegt wird, so daß der erste Hauptknoten (H1) mit einer von dem Produkt aus den entsprechenden Stellen der Binärzahlen abhängigen Ladungsträgermenge versehen wird, der erste Grundvorgang, der zweite Grundvorgang und der erste Grundvorgang durchgeführt werden und nachfolgend durch die Anwendung des dritten Grundvorgangs auf dem dritten Hauptknoten (H3) befindliche Überschußladungsträger auf den zweiten Hauptknoten (H2) des benachbarten Schaltungsblocks und auf dem zweiten Hauptknoten (H2) befindliche Überschußladungsträger auf den dritten Hauptknoten (H3) desselben Schaltungsblocks verschoben werden, wobei auf dem dritten Hauptknoten (H3) des letzten Schaltungsblocks befindliche Überschußladungsträger als Ergebnis für die entsprechende binäre Stelle zum Ausgang des letzten Schaltungsblocks verschoben werden,

- bei dem durch alternierende Anwendung des zweiten Grundvorgangs und des dritten Grundvorgangs die weiteren binären Stellen des Produktes sukzessive am Ausgang erzeugt werden.

**Claims**

1. Circuit arrangement having single-electron components,

- in which a circuit block is provided, having a first single-electron transistor (ET1), a second single-electron transistor (ET2), a third single-electron transistor (ET3), a fourth single-electron transistor (ET4) and a fifth single-electron transistor (ET5),
- in which the first single-electron transistor (ET1) is connected between a first main node (H1) and a second main node (H2), the second single-electron transistor (ET2) is connected between the second main node (H2) and a third main node (H3), and the third single-electron transistor (ET3) is connected between the third main node (H3) and an output (A),
- in which the fourth single-electron transistor (ET4) is connected between the second main node (H2) and a first supply voltage connection (V1), and the fifth single-electron transistor (ET5) is connected between the third main node (H3) and the first supply voltage connection (V1),
- in which the second main node (H2) is capacitively connected to a second supply voltage connection (V2), and the third main node (H3) is capacitively connected to a third supply voltage connection (V3),
- in which the gate electrode (G1) of the first single-electron transistor (ET1) is connected to a first control voltage connection (S1), the gate electrode (G2) of the second single-electron transistor (ET2) is connected to a second control voltage connection (S2), and the gate electrode (G3) of the third single-electron transistor (ET3) is connected to a third control voltage connection (S3),

- in which the gate electrode (G4) of the fourth single-electron transistor (ET4) is connected to the first main node (H1), and the gate electrode (G5) of the fifth single-electron transistor (ET5) is connected to the second main node (H2),
- in which the first main node (H1) is capacitively connected to a fourth supply voltage connection (V4), and the first main node (H1) is connected via a capacitive element to a fifth supply voltage connection (V5), with the fifth supply voltage connection (V5) being different to the first supply voltage connection (V1).

2. Circuit arrangement according to Claim 1, in which the second main node (H2) and the third main node (H3) are each connected via a capacitor (K2, K3) to the second supply voltage connection (V2) and to the third supply voltage connection (V3), respectively.

3. Circuit arrangement according to Claim 1 or 2,
   in which a sixth single-electron transistor (ET6) is provided, which is connected between the first main node (H1) and the fifth supply voltage connection (V5).

4. Circuit arrangement according to Claim 3,
   in which the gate electrode (G6) of the sixth single-electron transistor (ET6) is capacitively connected to the first supply voltage (V1).

5. Circuit arrangement according to Claim 4,

   - in which the gate electrode (G6) of the sixth single-electron transistor (ET6) is connected via a capacitor (K4) to the first supply voltage connection (V4),
   - in which the first main node (H1) is connected via a capacitor (K1) to the fourth supply voltage connection (V4).

6. Circuit arrangement according to one of Claims 1 to 5, in which a plurality of circuit blocks are provided, which are constructed in the same way as the first-mentioned circuit block and are connected in series, so that the output (A) of one of the circuit blocks is connected to the first main node (H1) of the adjacent circuit block.

7. Method for operation of a circuit arrangement according to one of Claims 1 to 6,

   - in which excess charge carriers are applied to the first main node (H1), to the second main node (H2) and to the third main node (H3) as a function of the logic value of a variable,
   - in which the logic values are logically linked by means of a combination of basic processes,
   - in which, in a first basic process, excess charge carriers located at the first main node (H1) flow to the second main node (H2), provided there are not already any excess charge carriers at the second main node (H2), and excess charge carriers located at the first main node (H1) flow to the tunnel element of the first single-electron transistor (ET1), provided there are excess charge carriers at the second main node (H2),
   - in which excess charge carriers located at the tunnel junction of the first single-electron transistor (ET1) then flow to the first main node (H1),
   - in which excess charge carriers located at the second main node (H2) then flow away via the fourth single-electron transistor (ET4) only when there are excess charge carriers at the first main node (H1),
   - in which, in a second basic process, excess charge carriers located at the second main node (H2) flow to the third main node (H3), provided there are not already any excess charge carriers at the third main node (H3), and excess charge carriers located at the second main node (H2) flow to the tunnel element of the second single-electron transistor (ET2), provided there are excess charge carriers at the third main node (H3),
   - in which excess charge carriers located at the tunnel element of the second single-electron transistor (ET2) then flow to the second main node (H2),
   - in which excess charge carriers located at the third main node (H3) flow away via the fifth single-electron transistor (ET5) only when there are excess charge carriers at the second main node (H2),
   - in which, in a third basic process, excess charge carriers are shifted from one main node to the adjacent main node by actuation of the single-electron transistor located between the adjacent main nodes.

8. Method according to Claim 7 in conjunction with Claim 3 and Claim 6,

   - in which, in order to multiply a first binary number by a second binary number, the digits of the first binary number are applied to the gate electrode (G6) of the sixth single-electron transistor (ET6) of the adjacent circuit blocks,

- in which the digit of the second binary number is then applied successively to the first supply voltage connection (V1) for all the digits of the second binary number, so that the first main node (H1) is provided with a number of charge carriers that depends on the product of the corresponding digits of the binary numbers, the first basic process, the second basic process and the first basic process are carried out and then, by application of the third basic process, excess charge carriers located at the third main node (H3) are shifted to the second main node (H2) of the adjacent circuit block, and excess charge carriers located at the second main node (H2) are shifted to the third main node (H3) of the same circuit block, with excess charge carriers located at the third main node (H3) of the last circuit block being shifted to the output of the last circuit block as the result for the corresponding binary digit,
- in which the further binary digits of the product are produced successively at the output, by alternating use of the second basic process and the third basic process.

**Revendications**

1. Agencement de circuit avec composants à électron unique,

   - dans lequel est prévu un bloc de circuit comportant un premier transistor à électron unique (ET1), un deuxième transistor à électron unique (ET2), un troisième transistor à électron unique (ET3), un quatrième transistor à électron unique (ET4) et un cinquième transistor à électron unique (ET5),
   - dans lequel le premier transistor à électron unique (ET1) est raccordé entre un premier noeud principal (H1) et un deuxième noeud principal (H2), le deuxième transistor à électron unique (ET2) est raccordé entre le deuxième noeud principal (H2) et un troisième noeud principal (H3) et le troisième transistor à électron unique (ET3) est raccordé entre le troisième noeud principal (H3) et une sortie (A),
   - dans lequel le quatrième transistor à électron unique (ET4) est raccordé entre le deuxième noeud principal (H2) et un premier raccordement de tension d'alimentation (V1) et le cinquième transistor à électron unique (ET5) est raccordé entre le troisième noeud principal (H3) et le premier raccordement de tension d'alimentation (V1),
   - dans lequel le deuxième noeud principal (H2) est relié capacitivement à un deuxième raccordement de tension d'alimentation (V2) et le troisième noeud principal (H3) est relié capacitivement à un troisième raccordement de tension d'alimentation (V3)
   - dans lequel l'électrode de grille (G1) du premier transistor à électron unique (ET1) est reliée à un premier raccordement de tension de commande (S1), l'électrode de grille (G2) du deuxième transistor à électron unique (ET2) est reliée à un deuxième raccordement de tension de commande (S2) et l'électrode de grille (G3) du troisième transistor à électron unique (ET3) est reliée à un troisième raccordement de tension de commande (S3),
   - dans lequel l'électrode de grille (G4) du quatrième transistor à électron unique (ET4) est reliée au premier noeud principal (H1) et l'électrode de grille (G5) du cinquième transistor à électron unique (ET5) est reliée au deuxième noeud principal (H2),
   - dans lequel le premier noeud principal (H1) est relié capacitivement à un quatrième raccordement de tension d'alimentation (V4) et le premier noeud principal (H1) est relié par l'intermédiaire d'un élément capacitif à un cinquième raccordement de tension d'alimentation (V5), le cinquième raccordement de tension d'alimentation (V5) étant distinct du premier raccordement de tension d'alimentation (V1).

2. Agencement de circuit selon la revendication 1, dans lequel le deuxième noeud principal (H2) et le troisième noeud principal (H3) sont reliés, chacun par l'intermédiaire d'un condensateur (K2, K3), au deuxième raccordement de tension d'alimentation (V2), respectivement au troisième raccordement de tension d'alimentation (V3).

3. Agencement de circuit selon la revendication 1 ou 2, dans lequel est prévu un sixième transistor à électron unique (ET6) qui est raccordé entre le premier noeud principal (H1) et le cinquième raccordement de tension d'alimentation (V5).

4. Agencement de circuit selon la revendication 3, dans lequel l'électrode de grille (G6) du sixième transistor à électron unique (ET6) est reliée capacitivement à la première de tension d'alimentation (V1).

5. Agencement de circuit selon la revendication 4,

   - dans lequel l'électrode de grille (G6) du sixième transistor à électron unique (ET6) est reliée par l'intermédiaire d'un condensateur (K4) au premier raccordement de tension d'alimentation (V1),

- dans lequel le premier noeud principal (H1) est relié par l'intermédiaire d'un condensateur (K1) au quatrième raccordement de tension d'alimentation (V4).

**6.** Agencement de circuit selon Tune des revendications 1 à 5, dans lequel sont prévus plusieurs blocs de circuit dont la structure est identique à celle du premier bloc de circuit mentionné et qui sont raccordés en série de telle sorte que la sortie (A) d'un des blocs de circuit soit raccordée au premier noeud principal (H1) du bloc de circuit voisin.

**7.** Procédé d'utilisation d'un agencement de circuit selon l'une des revendications 1 à 6,

- dans lequel des porteurs de charge en excès sont appliqués sur le premier noeud principal (H1), le deuxième noeud principal (H2) et le troisième noeud principal (H3) sous la dépendance de la valeur logique d'une grandeur,
- dans lequel une liaison logique entre les valeurs logiques est effectuée par une combinaison d'opérations de base,
- dans lequel, dans une première opération de base, des porteurs de charge en excès présents sur le premier noeud principal (H1) s'écoulent vers le deuxième noeud principal (H2) si aucun porteur de charge en excès n'est préalablement présent sur le deuxième noeud principal (H2) et des porteurs de charge en excès présents sur le premier noeud principal (H1) s'écoulent vers l'élément tunnel du premier transistor à électron unique (ET1) si des porteurs de charge en excès sont présents sur le deuxième noeud principal (H2),
- dans lequel des porteurs de charge en excès présents sur la transition tunnel du premier transistor à électron unique (ET1) s'écoulent ensuite vers le premier noeud principal (H1),
- dans lequel des porteurs de charge en excès présents sur le deuxième noeud principal (H2) ne traversent ensuite le quatrième transistor à électron unique (ET4) que si des porteurs de charge en excès sont présents sur le premier noeud principal (H1),
- dans lequel, dans une deuxième opération de base, des porteurs de charge en excès présents sur le deuxième noeud principal (H2) s'écoulent vers le troisième noeud principal (H3) si aucun porteur de charge en excès n'est préalablement présent sur le troisième noeud principal (H3) et des porteurs de charge en excès présents sur le deuxième noeud principal (H2) s'écoulent vers l'élément tunnel du deuxième transistor à électron unique (ET2) si des porteurs de charge en excès sont présents sur le troisième noeud principal (H3),
- dans lequel des porteurs de charge en excès présents sur l'élément tunnel du deuxième transistor à électron unique (ET2) s'écoulent ensuite vers le deuxième noeud principal (H2),
- dans lequel des porteurs de charge en excès présents sur le troisième noeud principal (H3) ne traversent le cinquième transistor à électron unique (ET5) que si des porteurs de charge en excès sont présents sur le deuxième noeud principal (H2),
- dans lequel, dans une troisième opération de base, des porteurs de charge en excès sont transférés d'un noeud principal vers le noeud principal voisin par commande du transistor à électron unique situé entre les noeuds principaux voisins.

**8.** Procédé selon la revendication 7, en association à la revendication 3 et à la revendication 6,

- dans lequel, pour la multiplication d'un premier nombre binaire par un deuxième nombre binaire, les chiffres du premier nombre binaire sont appliqués sur l'électrode de grille (G6) du sixième transistor à électron unique (ET6) des blocs de circuit voisins,
- dans lequel, successivement pour tous les chiffres du deuxième nombre binaire, les chiffres du deuxième nombre binaire sont ensuite appliqués sur le premier raccordement d'alimentation en tension (V1) de telle sorte que le premier noeud principal (H1) reçoive une quantité de porteurs de charge qui dépend du produit des chiffres correspondants des nombres binaires, la première opération de base, la deuxième opération de base et la première opération de base étant exécutées et ensuite, par l'application de la troisième opération de base, des porteurs de charge en excès présents sur le troisième noeud principal (H3) sont transférés vers le deuxième noeud principal (H2) du bloc de circuit voisin et des porteurs de charge en excès présents sur le deuxième noeud principal (H2) sont transférés vers le troisième noeud principal (H3) du même bloc de circuit, les porteurs de charge en excès présents sur le troisième noeud principal (H3) du dernier bloc de circuit étant transférés vers la sortie du dernier bloc de circuit comme résultat pour le chiffre binaire correspondant,
- dans lequel, par application alternée de la deuxième opération de base et de la troisième opération de base, les autres chiffres binaires du produit sont créés successivement sur la sortie.

FIG 1

EP 1 078 461 B1

FIG 2A

FIG 2B

FIG 2C

A3

SB3

G33 ET33 K33 H33 TK313 T33 TK323 TK323

G23 ET23 K23 H23 TK213 T23 TK223

G13 ET13 K13 H13 TK113 T13 TK123

TK513 G53 TK523 T53 ET53

TK413 G43 TK423 T43 ET43

TK613 G63 TK623 K43 T63 ET63

# FIG 3A

EP 1 078 461 B1

FIG 3B

FIG 3C

EP 1 078 461 B1

FIG 3D

# FIG 3E

EP 1 078 461 B1

FIG 3F

EP 1 078 461 B1

FIG 3G

EP 1 078 461 B1

FIG 3H

EP 1 078 461 B1

FIG 3I

EP 1 078 461 B1

# FIG 3J

ST3
VS3
ST2
VS2
ST1
VS4

H11  H21  H31  H12  H22  H32  H13  H23  H33  A3

ET11  ET21  ET31  ET12  ET22  ET32  ET13  ET23  ET33

ET61  ET41  ET51  ET62  ET42  ET52  ET63  ET43  ET53

G61  G62  G63

X  X  X  X  X

VS1
VS5

EP 1 078 461 B1

FIG 3K

FIG 3L

EP 1 078 461 B1

FIG 3M

EP 1 078 461 B1

# FIG 3N

EP 1 078 461 B1

# FIG 30

ST3
VS3
ST2
VS2
ST1
VS4

H11   H21   H31   H12   H22   H32   H13   H23   H33   A3

ET11   ET21   ET31   ET12   ET22   ET32   ET13   ET23   ET33

ET61   ET41   ET51   ET62   ET42   ET52   ET63   ET43   ET53

X

G61   X   G62   G63

VS1
VS5

EP 1 078 461 B1

# FIG 3P

EP 1 078 461 B1